# EUROPÄISCHE PATENTSCHRIFT

(11) **EP 1 932 866 B1**
(45) Veröffentlichungstag und Bekanntmachung des Hinweises auf die Patenterteilung: **13.07.2011**
(21) Anmeldenummer: 08003260.0
(22) Anmeldetag: 04.02.2004
(51) Int. Cl.: C08G 61/12, H01B 1/12, H01L 51/00, H01L 51/50

(54) **Blends enthaltend konjugierte Carbazol-Polymere, deren Darstellung und Verwendung**
Blends comprising conjugated carbazole polymers, synthesis and usage thereof
Mélanges conjugués comprenant du carbazol, leur représentation et utilisation

(30) Priorität: 06.02.2003 DE 10304819
(43) Veröffentlichungstag der Anmeldung: 18.06.2008
(62) Teilanmeldung aus: 04707888.6
(73) Patentinhaber: Merck Patent GmbH, 64293 Darmstadt (DE)
(72) Erfinder: Parham, Amir Dr., 65929 Frankfurt (DE); Breuning, Esther Dr., 65527 Niedernhausen (DE); Ludemann, Aurélie Dr., 60322 Frankfurt (DE); Heun, Susanne Dr., 65812 Bad Soden (DE); Becker, Heinrich Dr., 65719 Hofheim (DE)

(56) Entgegenhaltungen:
- WO-A-01/96454
- ZOTTI, SCHAVION, ZECCHIN, MORIN, LECLERC: "Electrochemical, conductive and magnetic properties of 2,7-Carbazole-based conjugated polymers" MACROMOLECULES, Bd. 35, 7. Februar 2002 (2002-02-07), Seiten 2122-2128, XP002281497
- WANG, HUA, ZHANG, WANG: "Synthesis and electroluminescent properties of heterocycle-containing poly(p-phenylene vinylene) derivatives" SYNTHETIC METALS, Bd. 99, 1999, Seiten 249-252, XP002281498
- HUANG ET AL.: "Synthesis and electrochemical characterization of a new polymer constituted of carbazole and oxadiazole moieties" SYNTHETIC METALS, Bd. 100, 1999, Seiten 297-301, XP002281499
- ZHU WEIGUO ET AL: "Highly efficient electrophosphorescent devices based on conjugated polymers doped with iridium complexes" APPLIED PHYSICS LETTERS, AIP, AMERICAN INSTITUTE OF PHYSICS, MELVILLE, NY, US, Bd. 80, Nr. 12, 25. März 2002 (2002-03-25), Seiten 2045-2047, XP012030357 ISSN: 0003-6951
- O'BRIEN D F ET AL: "ELECTROPHOSPHORESENCE FROM A DOPED POLYMER LIGHT EMITTING DIODE" SYNTHETIC METALS, ELSEVIER SEQUOIA, LAUSANNE, CH, Bd. 116, Nr. 1-3, Januar 2001 (2001-01), Seiten 379-383, XP001012225 ISSN: 0379-6779

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423 283 (WO 90/13148) offenbart sind. Seit kurzem ist auch ein erstes Produkt in Form einer kleineren Anzeige (in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit marktbeherrschenden Flüssigkristallanzeigen (LCD) zu machen bzw. diese zu überflügeln. Vor allem ist es hierbei erforderlich, Polymere für alle Emissionsfarben (rot, grün, blau) zur Verfügung zu stellen, die den Anforderungen des Marktes (Farbsättigung, Effizienz, operative Lebensdauer, Spannung, um die wichtigsten zu nennen) gerecht werden.

Als Polymere für vollfarbige Anzeigeelemente (sog. Full-Colour-Displays) wurden bereits verschiedene Materialklassen vorgeschlagen bzw. entwickelt. So kommen Polyfluoren-Derivate, wie beispielsweise in EP 0842208, WO 99/54385, WO 00/22027, WO 00/22026 und WO 00/46321 offenbart, in Betracht. Des Weiteren sind auch Poly-Spirobifluoren-Derivate, wie in EP 0707020, EP 0894107 und WO 03/020790 offenbart, eine Möglichkeit. Auch Polymere, die eine Kombination der beiden erstgenannten Strukturelemente enthalten, wie in WO 02/077060 offenbart, wurden bereits vorgeschlagen. Im Allgemeinen sind für derartigen Einsatz Polymere, welche Poly-para-Phenylen (PPP) als Strukturelement enthalten, möglich. Neben den oben bereits genannten Klassen kommen hier beispielsweise auch die so genannten Leiter-PPPs ("Ladder-PPPs" = LPPP) (z. B. gemäß WO 92/18552), die Poly-Tetrahydropyrene (z. B. gemäß EP-A-699699), aber auch Ansa-Strukturen enthaltende PPPs (z. B. gemäß EP-A-690086) in Frage.

Wie in einigen der o. g. Anmeldeschriften bereits heraus gearbeitet wurde, ist es für die Erzeugung aller drei Emissionsfarben notwendig, bestimmte Comonomere in die entsprechenden Polymere einzupolymerisieren (vgl. z. B. WO 00/46321, DE 10143353.0 und WO 02/077060). So ist dann i. d. R. - ausgehend von einem blau emittierenden Grundpolymer ("backbone") - die Erzeugung der beiden anderen Primärfarben Rot und Grün möglich.

Des Weiteren wurde berichtet, dass das Einfügen bestimmter Arylamino-Gruppierungen eine Verbesserung der Eigenschaften ergibt:
- WO 99/54385 beschreibt Polyfluorene, deren Effizienz und Einsatzspannung verbessert werden kann, indem Derivate von Triphenylamin, Tetraphenyl-p-diamino-benzol oder Tetraphenyl-4,4'-diamino-biphenyl in die Hauptkette der entsprechenden Polymere mit einpolymerisiert werden.
- DE 19846767 beschreibt Polyfluorene, bei denen ebenfalls die Effizienz und Einsatzspannung verbessert wird, indem substituierte Diarylamino-Einheiten in die Hauptkette eingebaut werden.
- WO 01/49769 beschreibt allgemein Polymere, welche Triarylamino-Gruppen enthalten, bei welchen mindestens eine der Arylgruppen eine Heteroarylgruppe darstellt. Besondere Vorteile dieser Polymere werden nicht beschrieben.
- WO 01/66618 beschreibt Copolymere, welche neben Aryleinheiten auch spezielle Triarylamino- bzw. Tetraaryl-p-diamino-arylen-Einheiten in der Hauptkette enthalten. Die entsprechenden Aminobausteine enthalten dabei jeweils mit Trifluormethylgruppen substituierte Phenyle, die direkt an die Stickstoffatome gebunden sind, allerdings nicht in die Hauptkette eingebaut werden. Als Vorteil wird erwähnt, dass diese Materialien - v. a. im Gegensatz zu den Derivaten, welche in der o. g. WO 99/54385 genannt werden - eine besser einstellbare HOMO-Lage besitzen und dies deshalb in der Anwendung Vorteile erbringt.

Trotz der in den o. g. Anmeldeschriften zitierten Fortschritte gibt es immer noch einen erheblichen Verbesserungsbedarf für entsprechende Materialien. U. a. auf folgenden Feldern sind noch deutliche Verbesserungen nötig:
(1) Die Strom-Spannungskennlinien müssen noch deutlich steiler werden, damit in der Anwendung große Helligkeit bei ausreichend niedrigen Spannungen und somit eine höhere Leistungseffizienz erzielt wird. Dies ist von enormer Bedeutung, da somit einerseits gleiche Helligkeit bei geringerem Energieverbrauch erzielt werden kann, was vor allem bei mobilen Applikationen (Displays für Handys, PDA etc.) sehr wichtig ist. Andererseits erhält man bei gleichem Energieverbrauch höhere Helligkeiten, was beispielsweise für Beleuchtungsanwendungen interessant sein kann.
(2) Viele der beschriebenen BLAU emittierenden Polymere zeigen keine gesättigte tiefblaue Emission, sondern eine hellblaue Emission, deren Farbsättigung nicht für alle Anwendungen ausreichend ist.

Wie aus dieser Beschreibung des Stands der Technik ersichtlich ist, besteht daher weiterhin ein großer Bedarf an Verbesserungen auf dem Gebiet der lichtemittierenden Polymere.

So wurde gefunden, dass Polymere, die bestimmte Carbazol-Einheiten enthalten, deutliche Verbesserungen, gerade auf den beiden o. g. Gebieten, d. h. der Steilheit der Strom-Spannungs-Kennlinien (und damit der Betriebsspannung) und der Farbe, ergeben.

Dies sind konjugierte Polymere (POLY1), die 1 - 100 mol%, bevorzugt 5 - 100 mol%, besonders bevorzugt 10 - 100 mol% Einheiten gemäß Formel (I) enthalten, 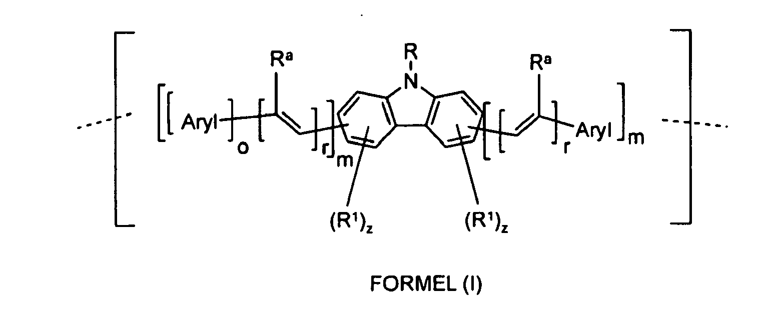 wobei die Symbole und Indizes folgende Bedeutung besitzen:
- R: ist bei jedem Auftreten gleich oder verschieden einem Cycloalkylsystem mit 3 bis 40 C-Atomen, welches substituiert oder unsubstituiert sein kann, einem aromatischen oder heteroaromatischen Ringsystem mit 2 bis 40 C-Atomen, welches substituiert oder unsubstituiert sein kann, oder einem Alkylenaryl-, Alkylencycloalkyl- oder Alkylenheteroaryl-System mit linearer oder verzweigter Alkylenkette mit 1 bis 16 C-Atomen, welches substituiert oder auch unsubstituiert sein kann; die Aryl-, Heteroaryl- und Cycloalkyl-Systeme können dabei auch Teil eines größeren kondensierten aromatischen oder aliphatischen Ringsystems sein; die möglichen Substituenten R¹ können potentiell an jeder freien Position sitzen;
- Aryl: sind bei jedem Auftreten gleich oder verschieden einem aromatischen oder heteroaromatischen Ringsystem mit 2 bis 40 C-Atomen, welches substituiert oder auch unsubstituiert sein kann, oder eine substituierte oder unsubstituierte Stilbenylen- oder Tolanyleneinheit; die möglichen Substituenten R¹ können dabei potentiell an jeder freien Position sitzen;
- R¹: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R², O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R²)₂, B(R²)₂, wobei auch zwei oder mehrere Reste R¹ miteinander ein Ringsystem bilden können;
- R^{a}: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R², O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R²)₂, B(R²)_{2,};
- R²: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können;
- m: ist bei jedem Auftreten gleich oder verschieden 0, 1 oder 2;
- o: ist bei jedem Auftreten gleich oder verschieden 0, 1 oder 2, unter der Bedingung, dass o nicht 0 sein darf, wenn m = 2 ist;
- r: ist bei jedem Auftreten gleich oder verschieden 0 oder 1,
- z: ist bei jedem Auftreten gleich oder verschieden 0, 1, 2 oder 3;

die gestrichlte Bindung bedeutet dabei die Verknüpfung im Polymer; sie soll hier keine Methylgruppe darstellen.

Dabei sind verschiedene Verknüpfungen für die Carbazoleinheit in der Polymerkette möglich: Verknüpfung an nur einer der Stellen führt zu einer Endgruppe oder zum Einbau der Struktureinheit gemäß Formel (I) in die Seitenkette; Verknüpfung an zwei Stellen führt zum Einbau des Monomers in die Hauptkette des Polymers; der Einbau der Struktureinheit gemäß Formel (I) in die Hauptkette erfolgt bevorzugt über die 3,6- oder die 2,7-Position des Carbazols oder aber auch über die 2,9- oder 3,9-Position, sofern in den letzten beiden Fällen R ein aromatisches oder heteroaromatisches Ringsystem beschreibt, damit die Konjugation des Polymers gewahrt bleibt. Besonders bevorzugt erfolgt der Einbau über die 3,6- oder die 2,7-Position oder über die 3,9-Position, sofern R ein aromatisches oder heteroaromatisches Ringsystem beschreibt. Ganz besonders bevorzugt erfolgt der Einbau über die 3,6- oder die 2,7-Position. Zur Klarheit wird die Nummerierung des Carbazols in folgender Struktur aufgezeigt:

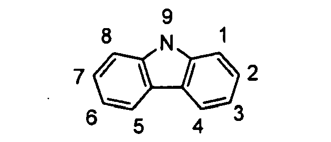

Konjugierte Polymere im Sinne dieser Anmeldung sind Polymere, die in der Hauptkette hauptsächlich sp²-hybridisierte (bzw. auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich auftretende Defekte, die zu Konjugationsunterbrechungen führen, den Begriff "konjugierte Polymere" nicht entwerten. Des Weiteren wird in diesem Anmeldetext ebenfalls als konjugiert bezeichnet, wenn sich in der Hauptkette beispielsweise Arylamineinheiten wie das Carbazol gemäß Formel (I) oder andere derartige Einheiten und/oder bestimmte Heterocyclen (d. h. Konjugation über N-, O- oder S-Atome) und/oder metallorganische Komplexe (d. h. Konjugation über das Metallatom) befinden. Hingegen würden Einheiten wie beispielsweise einfache (Thio)Etherbrücken, Esterverknüpfungen, Amid- oder Imidverknüpfungen eindeutig als nicht-konjugierte Segmente definiert.

Die Polymere können neben den Einheiten gemäß Formel (I) noch weitere Strukturelemente enthalten. Dies sind u. a. solche, wie sie in den o. g. Patentanmeldungen bereits offenbart sind. Hier sei vor allem auch auf die relativ umfangreiche Auflistung in der oben schon erwähnten Anmeldeschrift WO 02/077060 verwiesen; diese wird via Zitat als Bestandteil der vorliegenden Erfindung betrachtet. Die weiteren Struktureinheiten können beispielsweise aus den im Folgenden beschriebenen Klassen stammen:
1. Struktureinheiten, die das Polymergrundgerüst bilden können, bzw. BLAU emittierende Einheiten:
   - Hier sind zunächst Poly-Phenylene und davon abgeleitete Strukturen bildende Einheiten zu nennen. Dies sind beispielsweise (jeweils substituierte oder unsubstituierte) ortho-, meta- oder para-Phenylene, 1,4-Naphthylene, 9,10-Anthracenylene, 2,7-Phenanthrenylene, 1,6- bzw. 2,7- bzw. 4,9-Pyrenylene oder 2,7-Tetrahydropyrenylene. Auch entsprechende heterocyclische "Poly-Phenylen"-bildende Strukturen, wie beispielsweise 2,5-Thiophenylen, 2,5-Pyrrolylen, 2,5-Furanylen, 2,5-Pyridylen, 2,5-Pyrimidinylen oder 5,8-Chinolinylen kommen in Frage.
   - Des Weiteren sind komplexere Einheiten, wie die o. g. Fluorene, Spiro-9,9'-bifluorene, mehrfach überbrückte Einheiten (z. B. kurze Teilsegmente der o. g. LPPP-Polymere), aber auch "doppelte Fluoren"-Einheiten (Indenofluorene) möglich. Auch diese können substituiert bzw. unsubstituiert sein. Auch entsprechende heterocyclische Strukturen, in denen beispielsweise einzelne Ringkohlenstoffatome durch Heteroatome, wie beispielsweise Schwefel, ersetzt sind, kommen hier in Frage.
2. Struktureinheiten, die die Ladungsinjektions- bzw.
   Ladungstransporteigenschaften erhöhen. Dies kann sich sowohl auf die Elektroneninjektions- oder -transporteigenschaften (wie beispielsweise Oxadiazol-Einheiten) wie auch auf die Lochinjektions- oder -transporteigenschaften (wie beispielsweise Triarylamin-Einheiten) beziehen. Hier sei nochmals auf umfangreiche Auflistung derartiger Struktureinheiten in der oben zitierter Anmeldeschrift WO02/077060 verwiesen; diese wird via Zitat als Bestandteil der vorliegenden Erfindung betrachtet. Ebenso kommen für diesen Zweck Naphthyl-Aryl-Amine in Frage, wie sie in der nicht offengelegten Anmeldeschrift DE 10249723.0 beschrieben werden.
3. Struktureinheiten, die beispielsweise die Farbe der Emission verschieben, damit auch die Bandlücke des Polymers verändern und somit i. d. R. auch die Ladungsinjektions- bzw. -transporteigenschaften verändern:
   - Hier sind beispielsweise weitere heterocyclische Verbindungen, wie die in der o. g. Anmeldung WO 02/077060 unter den Formeln (XX) bis (XXXXV) genannten Strukturen zu nennen.
   - Des weiteren sind hier auch Arylenvinylen- oder Arylenacetylen-Strukturen, wie substituierte oder unsubstituierte Stilbenylene, Tolanylene, Bisstyrylarylene, Bis(arylacetylen)-arylene zu nennen.
   - Schließlich kann auch der Einbau von größeren aromatischen Einheiten, wie zum Beispiel Chrysenen, Naphthacenen, Pentacenen, Perylenen oder Coronenen, den o. g. farbverschiebenden Effekt erzeugen.
4. Struktureinheiten, welche auch bei Raumtemperatur mit hoher Effizienz aus dem Triplettzustand Licht emittieren können:
   - Hier sind zunächst vor allem Verbindungen, welche Schweratome, d. h. Atome aus dem Periodensystem der Elemente mit einer Ordnungszahl von mehr als 36, enthalten, zu verstehen.
   - Besonders geeignet hierfür sind Verbindungen, welche d- und f-Übergangsmetalle enthalten, die die o. g. Bedingung erfüllen. Ganz besonders bevorzugt sind hier entsprechende Struktureinheiten, welche Elemente der Gruppe 8 bis 10 (d. h. Ru, Os, Rh, Ir, Pd, Pt) enthalten.
   - Als Struktureinheiten für die erfindungsgemäßen Polymere kommen hier verschiedene Komplexe in Frage, welche beispielsweise in den Anmeldeschriften WO 02/068435, WO 02/081488, EP 1239526 und der nicht offen gelegten Anmeldeschrift DE 10238903.9 beschrieben sind.

Eine Auswahl bevorzugter weiterer Einheiten der Polymere sind in der folgenden Übersicht aufgelistet:

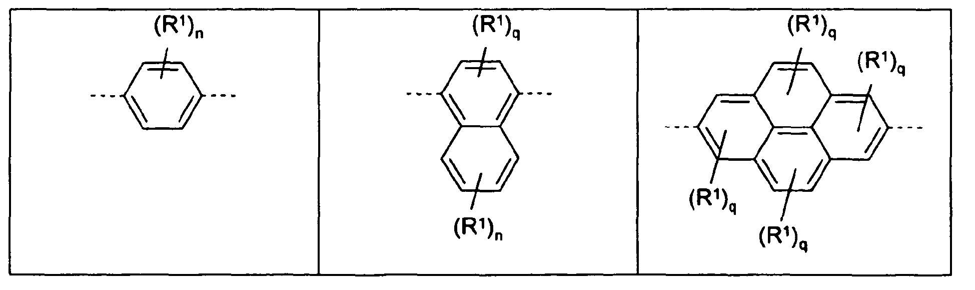

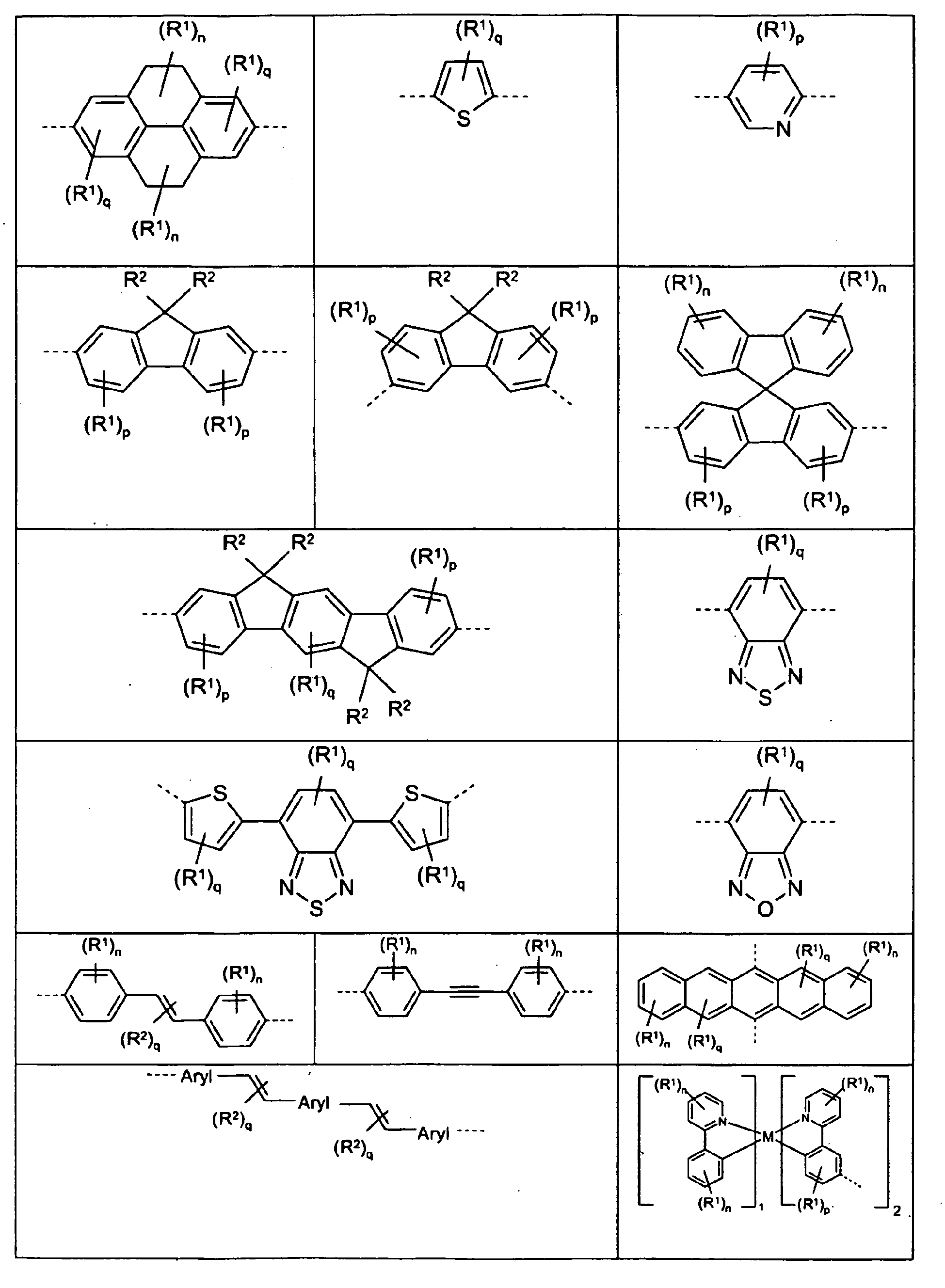

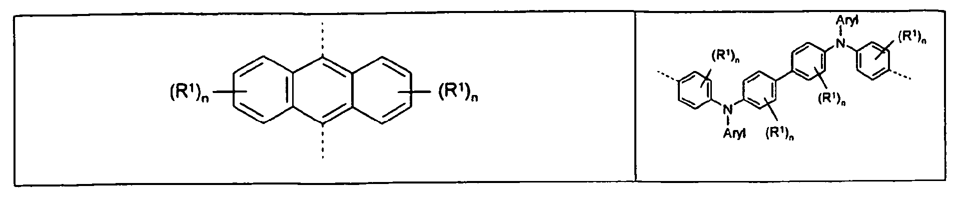

Die dabei verwendeten Symbole Aryl, R¹ und R² sind analog den oben bereits Beschriebenen zu verstehen.
- n: ist bei jedem Auftreten gleich oder verschieden 0, 1, 2, 3 oder 4;
- p: ist bei jedem Auftreten gleich oder verschieden 0, 1, 2 oder 3;
- q: ist bei jedem Auftreten gleich oder verschieden 0, 1 oder 2;
- M: ist bei jedem Auftreten gleich oder verschieden Rh oder Ir;
mit den abgebildeten gestrichelten Bindungen ist jeweils die Verknüpfung im Polymer symbolisiert; diese sollen hier keine Methylgruppen darstellen.

Die Polymere sind entweder Homopolymere, d. h. sie enthalten dann nur eine Struktur der Formel (I), oder es sind Copolymere. Hierbei kann es bevorzugt sein, dass diese entweder mehrere verschiedene Struktureinheiten gemäß Formel (I) enthalten oder neben einer oder mehrerer Struktureinheit(en) gemäß Formel (I), eine oder mehrere der oben beschriebenen bzw. aufgezählten Struktureinheiten enthalten.

Die Copolymere können sowohl statistische als auch alternierende oder auch blockartige Strukturen aufweisen oder auch mehrere dieser Strukturen abwechselnd besitzen. Durch das Verwenden mehrerer verschiedener Strukturelemente können Eigenschaften wie Löslichkeit, Festphasenmorphologie, Farbe etc. eingestellt werden.

Wie oben beschrieben, enthalten besonders bevorzugte Polymere mindestens 10 mol% Struktureinheiten gemäß Formel (I). Gerade für die Anwendung in den genannten PLEDs als emittierendes Material hat sich ein Anteil in dieser Größenordnung als günstig erwiesen. Für andere Anwendungen, z. B. als Ladungstransportschicht in organischen Feld-Effekt-Transistoren (OFETs), kann sich auch ein deutlich höherer Anteil (bis zu 100 mol%) als günstig erweisen.

Für bevorzugte Strukturen gemäß Formel (I) gilt Folgendes:
- R: ist bei jedem Auftreten gleich oder verschieden einem aromatischen oder heteroaromatischen Ringsystem, ausgewählt aus Thiophen, Benzothiophen, Benzol, Pyridin, Chinoxalin, Fluoren, Spirobifluoren, Naphthalin, Anthracen, Pyren oder Phenanthren, welches an den freien Positionen 0 bis 3 Substituenten R¹ trägt, oder einem Alkylen-aryl- oder Alkylen-heteroaryl-Ringsystem, dessen Alkylen-Kette linear oder verzweigt sein kann und aus 1 bis 16 C-Atomen besteht, und dessen Aryl- und Heteroaryl-System aus den oben im einzelnen aufgeführten Systemen besteht, welche an den freien Positionen 0 bis 3 Substituenten R¹ tragen;
- Aryl: ist bei jedem Auftreten gleich oder verschieden einem aromatischen oder heteroaromatischen Ringsystem mit 2 bis 40 C-Atomen, welches substituiert oder auch unsubstituiert sein kann; die Aryl- und Heteroaryl-Systeme können dabei auch Teil eines größeren kondensierten aromatischen Ringsystems sein; die möglichen Substituenten R¹ können, wenn vorhanden, an jeder freien Position sitzen;
- R¹, R² R^{a}, r, z: sind analog den oben gemachten Angaben;
- m: ist bei jedem Auftreten gleich oder verschieden 0 oder 1;
- o: ist bei jedem Auftreten gleich oder verschieden 0, 1 oder 2;
die Verknüpfung der Struktureinheit gemäß Formel (I) in die Hauptkette des Polymers erfolgt über die 3,6- oder 2,7-Position oder über die 2,9- oder 3,9-Position, sofern R eine aromatische oder heteroaromatische Einheit ist.

Für besonders bevorzugte Strukturen gemäß Formel (I) gilt Folgendes:
- R: ist bei jedem Auftreten gleich oder verschieden einem aromatischen oder heteroaromatischen Ringsystem, ausgewählt aus Thiophen, Benzothiophen, Benzol, Pyridin, Naphthalin, Anthracen, Pyren oder Phenanthren, welche unsubstituiert oder mit einem Substituenten R¹ substituiert sind, oder einem 9,9'-substituierten Fluoren oder einem Methylen-aryl- oder Methylen-heteroaryl-Ringsystem, dessen Aryl-bzw. Heteroaryl-System aus den oben im einzelnen aufgeführten Systemen besteht, welche dasselbe Substitutionsmuster tragen können wie die oben genannten Systeme;
- Aryl: ist bei jedem Auftreten gleich oder verschieden einem aromatischen oder heteroaromatischen Ringsystem mit 2 bis 20 C-Atomen, welches substituiert oder auch unsubstituiert sein kann; die Aryl- und Heteroaryl-Systeme können dabei auch Teil eines größeren kondensierten aromatischen Ringsystems sein; die möglichen Substituenten R¹ können dabei potentiell an jeder freien Position sitzen;
- R¹, R², R^{a}, r: sind analog den oben gemachten Angaben;
- m: ist bei jedem Auftreten gleich oder verschieden 0 oder 1;
- o: ist bei jedem Auftreten gleich oder verschieden 0 oder 1;
- z: ist bei jedem Auftreten gleich oder verschieden 0 oder 1;
die Verknüpfung der Struktureinheit gemäß Formel (I) in die Hauptkette des Polymers erfolgt über die 3,6-Position, die 2,7-Position oder die 3,9-Position, sofern R ein Aryl- oder Heteroarylsystem ist.

Besonders bevorzugte Strukturen gemäß Formel (I) sind substituierte oder unsubstituierte Strukturen gemäß den abgebildeten Formeln (II) bis (XXXI), wobei die gestrichelten Bindungen die Verknüpfung im Polymer definieren und potentielle Substituenten wegen der besseren Übersichtlichkeit i. d. R. nicht abgebildet sind:

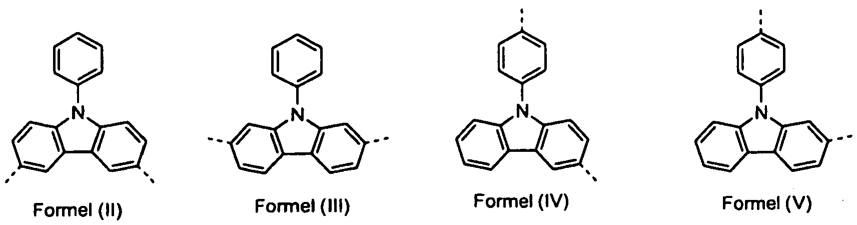

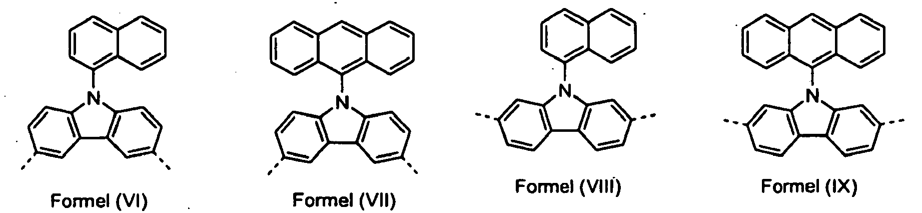

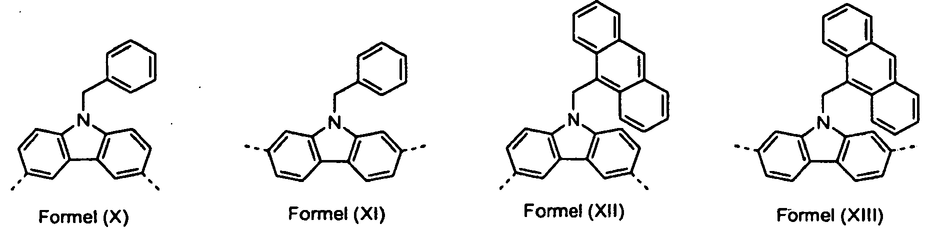

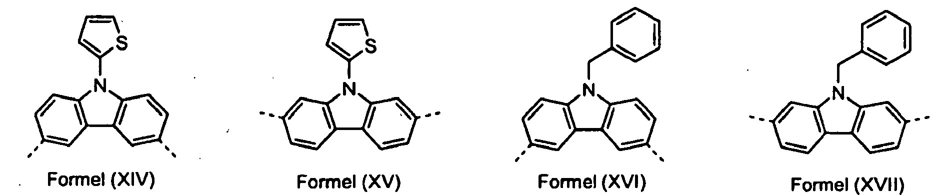

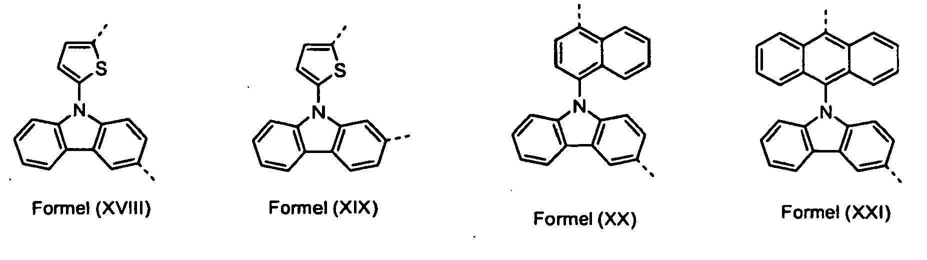

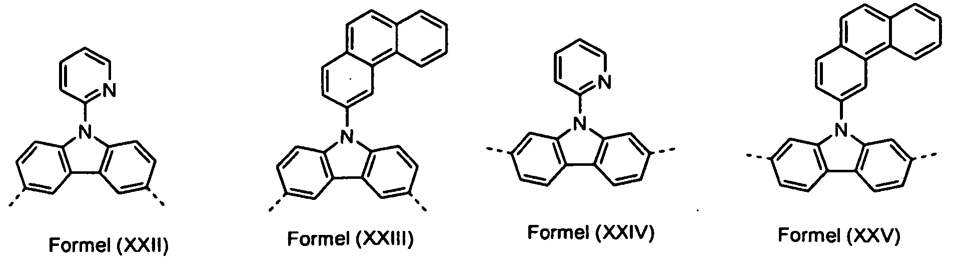

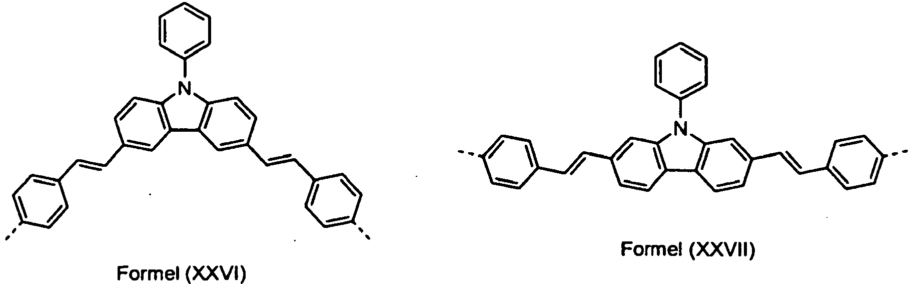

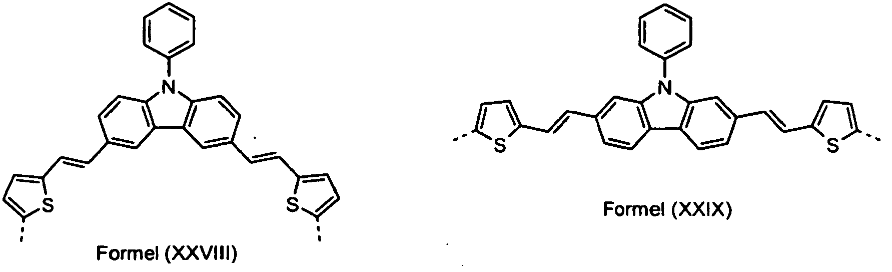

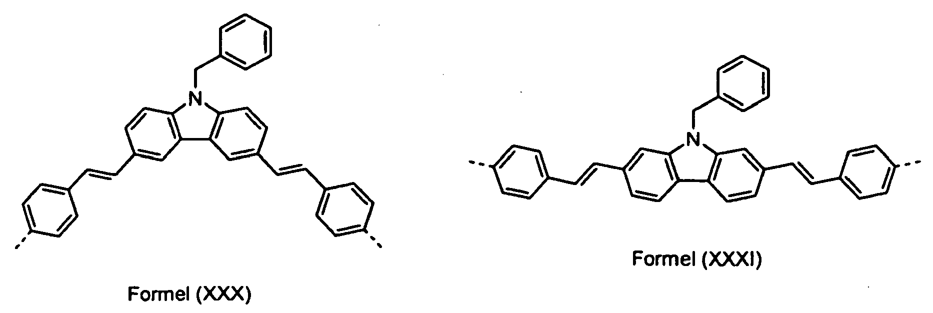

Für ganz besonders bevorzugte Strukturen gemäß Formel (I) gilt Folgendes:
- R: ist bei jedem Auftreten gleich oder verschieden einem aromatischen oder heteroaromatischen Ringsystem, ausgewählt aus Thiophen, Benzothiophen, Benzol, Naphthalin, Anthracen, oder Phenanthren, welche unsubstituiert oder mit einem Substituenten R¹ substituiert
- Aryl: sind, oder einer Benzylgruppe, dessen Phenylgruppe dasselbe Substitutionsmuster tragen kann wie die oben genannten Systeme; ist bei jedem Auftreten gleich oder verschieden einem aromatischen oder heteroaromatischen Ringsystem mit 2 bis 20 C-Atomen, welches substituiert oder auch unsubstituiert sein kann; die Aryl- und Heteroaryl-Systeme können dabei auch Teil eines größeren kondensierten aromatischen Ringsystems sein; die möglichen Substituenten R¹ können dabei potentiell an jeder freien Position sitzen;
- R¹, R², R^{a}, r: sind analog den oben gemachten Angaben;
- m: ist bei jedem Auftreten gleich oder verschieden 0 oder 1;
- o: ist bei jedem Auftreten gleich 1;
dabei erfolgt die Verknüpfung in die Polymerkette über die 3,6- oder die 2,7-Position des Carbazols.

Auch wenn dies aus der Beschreibung hervorgeht, sei hier nochmals explizit darauf verwiesen, dass sowohl die Struktureinheiten gemäß Formel (I), als auch jene gemäß den Formeln (II) bis (XXXI) unsymmetrisch substituiert sein können, d. h. an einer Einheit unterschiedliche Substituenten R¹ vorhanden sein können, bzw. diese auch an unterschiedliche Positionen gebunden sein können.

Die Polymere weisen in der Regel 10 bis 10000, bevorzugt 50 bis 5000, besonders bevorzugt 50 bis 2000 Wiederholeinheiten auf. Dabei beträgt die Polydispersität PD bevorzugt weniger als 10, besonders bevorzugt weniger als 5.

Die nötige Löslichkeit wird v. a. durch die Substituenten R¹, sowohl an Strukturen gemäß Formel (I), als auch an solchen, die, wie oben geschildert, in entsprechenden Copolymeren noch zusätzlich vorhanden sind, erreicht.

In der Regel ist es deshalb nötig, dass im Durchschnitt pro Wiederholeinheit mindestens 2 nicht-aromatische C-Atome in den Substituenten vorhanden sind. Bevorzugt sind dabei mindestens 4, besonders bevorzugt mindestens 8 C-Atome. Einzelne dieser C-Atome können auch noch durch O oder S ersetzt sein. Dies schließt nicht aus, dass ein gewisser Anteil von Wiederholeinheiten, sowohl solche gemäß Formel (I) als auch anderer Strukturtypen, keine weiteren nicht-aromatischen Substituenten tragen.

Es ist bevorzugt, keine langkettigen Substituenten mit mehr als 12 C-Atomen, bevorzugt keine mit mehr als 8 C-Atomen, besonders bevorzugt keine mit mehr als 6 C-Atomen in einer linearen Kette zu haben, um die Morphologie des Filmes nicht zu verschlechtern.

Nicht-aromatische C-Atome sind, wie in der Beschreibung für R¹, in entsprechenden geradkettigen, verzweigten oder cyclischen Alkyl- oder Alkoxyketten enthalten.

Bevorzugt sind deshalb weiterhin Polymere, bei denen gilt:
- R¹: ist bei jedem Auftreten gleich oder verschieden eine geradkettige, verzweigte oder cyclische Alkyl- oder Alkoxykette mit 1 bis 10 C-Atomen, wobei auch ein oder mehrere H-Atome durch Fluor ersetzt sein können, oder eine Arylgruppe mit 6 bis 14 C-Atomen, welche auch durch ein oder mehrere nicht-aromatische Reste R¹ substituiert ist.

Weiterhin besonders bevorzugt sind deshalb Polymere, bei denen gilt:
- R¹: ist bei jedem Auftreten gleich oder verschieden eine geradkettige oder verzweigte Alkyl- oder Alkoxykette mit 1 bis 8 C-Atomen, oder eine Arylgruppe mit 6 bis 10 C-Atomen, welche auch durch ein oder mehrere nicht-aromatische Reste R¹ substituiert ist.

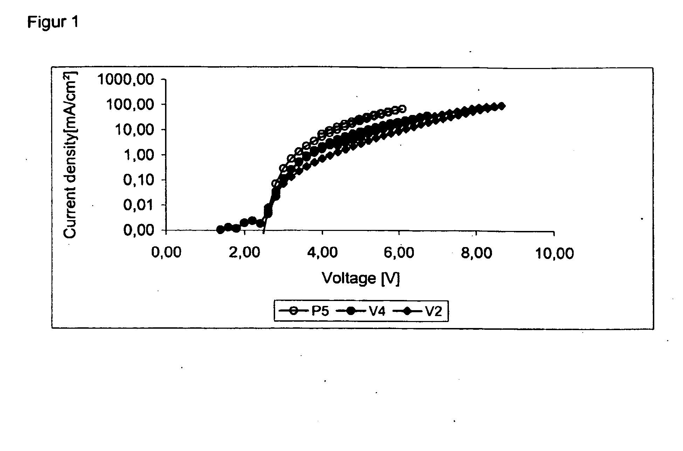

Die Polymere weisen u. a. folgende überraschenden Vorteile auf:
- Der Strom bei gegebener Spannung ist bei vergleichbaren Polymeren bei der Verwendung in PLEDs deutlich höher (vgl. Angaben in Tabelle 2 und in Abbildung 1), d. h. die Strom-Spannungs-Kennlinie ist steiler, wenn das Polymer Struktureinheiten der Formel (I) enthält. Dies bringt für die Anwendung - wie oben bereits ausgeführt - deutliche Vorteile, da somit das Ziel, effiziente Vollfarbdisplays mit geringerem Energieverbrauch zu erzeugen, ermöglicht wird.
- Überraschend hat die Verwendung von Polymeren, die Einheiten der Formel (I) enthalten, für die Erzeugung blauer Emission noch weitere Vorteile: Die Emissionsfarbe wird noch tiefer (d. h. tiefblau), als diejenige bei analogen Polymeren ohne Struktureinheiten gemäß Formel (I) (vgl. beispielsweise Polymere P1 und P2 mit Polymer V1 und V2).
- Entsprechende Copolymere können so aufgebaut werden, dass diese alle Grundfarben (rot, grün, blau) emittieren können.
- Die Löslichkeit in organischen Lösemitteln ist i. d. R. gut, d. h. in Lösemitteln, wie beispielsweise Toluol, Xylol, Anisol, Methylanisol oder Methylnaphthalin, sind die Polymere in Konzentrationen von 1 bis mindestens 30 g/L (je nach Molekulargewicht) löslich.

Die Polymere werden in der Regel durch Polymerisation von einem oder mehreren Monomeren, von denen mindestens eines Strukturen der Formel (I) enthält, hergestellt.

Entsprechende Polymerisationsreaktionen gibt es prinzipiell relativ viele verschiedene; es haben sich jedoch die im Folgenden aufgeführten Typen, die alle zu C-C-Verknüpfungen führen, besonders bewährt:
(A) Polymerisation gemäß SUZUKI
(B) Polymerisationen gemäß YAMAMOTO
(C) Polymerisationen gemäß STILLE
(D) Polymerisationen gemäß HARTWIG / BUCHWALD Genauere Ausführungen zu den Polymerisationsmethoden (A) bis (D) können beispielsweise in der nicht offen gelegten Anmeldung DE 10249723.0 gefunden werden. Für Polymere, die Doppelbindungen (Alken-Einheiten) enthalten, kommen auch folgende Methoden zur Polymerisation in Frage:
(E) Polymerisation gemäß WITTIG-HORNER: Hierbei werden als Monomere zum einen Bisaldehyde, zum anderen Bisphosphonate oder entsprechende

Monoaldehyd-monophosphonate eingesetzt und unter basischen Bedingungen in Anwesenheit von Lösemitteln zu den entsprechenden Alkenverbindungen umgesetzt. Derartige Reaktionen, welche zu konjugierten Polymeren führen, sind bereits beschrieben: (i) A. P. Davey *et al., Synth. Met.* **1999**, *103*, 2478, (ii) S.-H. Jin *et al., Eur. Polym. J.* **2002**, *38*, 895. Die entsprechenden Beschreibungen werden hiermit via Zitat als Bestandteil der Anmeldung erachtet.

(F) Polymerisation nach Precursor-Methoden (beispielsweise Sulfoxy Precursor Methode): Ausgehend von Bis(chlormethyl)-Verbindungen, die in der Lage sind, ein Chinodimethan zu bilden, werden zunächst durch einseitige Substitution Alkylthiomethyl-Chlormethyl-Intermediate erhalten. Daraus wird durch Oxidation das Sulfoxid gewonnen. Dieses Vorläufer-Monomer wird unter Bedingungen der Gilch-Polymerisation umgesetzt, wobei das effektive Monomer ein Alkylsulfoxychinodimethan ist. Das somit erhaltene relativ temperaturstabile Vorläufer-Polymer stellt ein Poly(arylen-alkylsulfoxyethylen) dar, das durch reine Temperaturbehandlung unterhalb 200 °C Alkylsulfinsäure eliminiert, unter Bildung des vollständig konjugierten Polymers. Diese Reaktionen sind u. a. in den folgenden Stellen aufgeführt: (i) WO 00/35987 (ii) A. Issaris, D. Vanderzande, Macromolecules 1998, 31, 4426-4431. Die entsprechenden Beschreibungen werden hiermit via Zitat als Bestandteil der Anmeldung erachtet.

Wie die Polymerisationen bevorzugt durchgeführt werden können und wie die Polymere dann von der Reaktionslösung abgetrennt und aufgereinigt werdne, ist beispielsweise in der nicht offen gelegten Anmeldung DE 10249723.0 beschrieben.

Um die entsprechenden Polymere beispielsweise durch die o. g. Verfahren herstellen zu können, benötigt man - wie beschrieben - die entsprechenden Monomere.

Für Strukturen gemäß Formel (I) können diese beispielsweise wie im Folgenden beschrieben erhalten werden:
- Die Synthese von 3,6-Dibromcarbazol erfolgt durch Bromierung des Carbazols, wie in der Literatur beschrieben: Smith et al., Tetrahedron 1992, 48, 7479-7488.
- Die Synthese von 2,7-Dibromcarbazol erfolgt durch Aufbau des Carbazols, wie in der Literatur beschrieben: Tidwell et al., Eur. J. Med. Chem. 1997, 32, 781-793.
- Eine entsprechende Funktionalisierung, die eine Verwendung als Monomere ermöglicht (also z. B. Einführung von Halogen-Endgruppen), kann entweder an den Vorstufen erfolgen oder als letzter Schritt an dem bereits vollständig aufgebauten monomeren Grundgerüst. Beide Varianten haben, je nach angestrebter Zielstruktur, sowohl Vor- als auch Nachteile.
- Vorab können die Funktionalitäten bereits vorhanden sein, wenn diese bei der Reaktion zum entsprechenden Monomer entweder nicht oder sehr erschwert reagieren. Dies kann z. B. der Fall sein bei einfacher Substitutionsreaktion, oder wenn man unterschiedliche Reaktivitäten (z. B. Iod gegenüber Brom, bzw. Brom gegenüber Chlor) ausnutzen kann. So kann beispielsweise ein Monomer, das Struktureinheiten gemäß Formel (III) ergibt, unter Ausnutzung der Selektivität von Iod gegenüber Brom hergestellt werden, wie in Beispiel 2 beschrieben.
- Andererseits kann es auch vorteilhaft sein (bei z. B. vorliegender Substitution bzw. dirigierenden Resten), zunächst den N-substituierten Carbazolgrundkörper aufzubauen und in einem letzten Schritt das Halogenid einzuführen. So ist es beispielsweise für Strukturen gemäß Formel (II) möglich, in die 3 und 6 Positionen des Carbazols Brom einzuführen (beispielsweise durch milde NBS-Bromierung, vgl. z. B. Creason et al., J. Org. Chem, 1972, 37, 4440), wenn an dem N-Arylsubstituenten in para-Stellung ein Substituent vorhanden ist. Wie oben geschildert, kann dieses Verfahren bei Vorhandensein (i) entsprechender blockierender Substituenten, (ii) entsprechend dirigierender Reste oder (iii) aktivierter bzw. deaktivierter Heterocyclen auch für weitere Strukturen gemäß Formel (I) im Allgemeinen angewendet werden.
- Die N-Alkylierung oder N-Benzylierung von Carbazolen ist in der Literatur bekannt. Ebenso können N-Alkylaryl- und N-Cycloalkyl-Carbazole gewonnen werden. Die Synthese erfolgt durch Reaktion des Carbazols mit einem Alkylierungsmittel unter basischen Bedinungen, wie beispielsweise beschrieben in: M. E. Wright, M.-J. Jin, J. Org. Chem. 1989, 54, 965-968.
- Die N-Arylierung des Carbazols kann gemäß Hartwig-Buchwald erfolgen und wird für Carbazol beispielsweise beschrieben in: M. Watanabe et al., Tetrahedron Lett. 2000, 41, 481-483.
- Ausgehend von den so erzeugten Halogenidderivaten können über Standardverfahren entsprechende Bisboronsäurederivate bzw. Bisstannanderivate (die für die o. g. Polymerisationsverfahren der Typen A und C benötigt werden) hergestellt werden. Diese Verfahren sind dem Fachmann hinlänglich bekannt und bestehen i. d. R. darin, das vorhandene Halogen gegen ein Metall auszutauschen (z. B. Magnesium, Lithium) und dieses dann mit einer Boresterverbindung bzw. einer Trialkylzinnhalogenverbindung umzusetzen. Für die Herstellung von Boronsäurederivaten sind auch katalytische Verfahren zur direkten Umsetzung der Halogenide mit beispielsweise Diboranen unter Anwesenheit von Palladium bekannt. Vergleichbare Reaktionen sind auch für die entsprechenden Zinnverbindungen bekannt. Entsprechende Monohalogenidmonoboronsäure-Derivate bzw. Monohalogenid-monostannan-Verbindungen sind bei geeigneter Stöchiometrie auch erhältlich.
- Ausgehend von den Halogenidderivaten können ebenfalls die entprechenden Bisaldehydderivate, die für das o. g. Polymerisationsverfahren des Typs E benötigt werden, hergestellt werden. Dieses Verfahren ist dem Fachmann hinlänglich bekannt und besteht i. d. R. darin, das vorhandene Halogen gegen ein Metall auszutauschen (z. B. Magnesium, Lithium) und dieses dann mit Ameisensäurederivat (z. B. Dimethylformamid) umzusetzen.
- Die entsprechenden Phosphonatderivate, die für das o. g. Polymerisationsverfahren des Typs E benötigt werden, können ausgehend von den entsprechenden Methylenhalogenidverbindungen erzeugt werden, die dann mit phosphoriger Säure Trialkylester umgesetzt werden. Derartige Verfahren sind dem Fachmann hinlänglich bekannt.

Die Synthese der weiteren Monomere, welche zu Strukturen führen, die nicht denen der Formel (I) entsprechen, die aber oben beschrieben wurden, ist in den bereits oben genannten Anmeldeschriften und Patenten ausführlich beschrieben.

Einen guten Überblick hierzu gibt dabei die Anmeldeschrift WO 02/077060; die dort gemachten entsprechenden Ausführungen werden via Zitat als Bestandteil dieser Anmeldung betrachtet.

Die so erhaltenen Polymere können als Einzelkomponente in unten näher beschriebenen Anwendungen verwendet werden. Sie können auch als Blends (Mischungen des Polymers mit weiteren polymeren oder niedermolekularen Komponenten) verwendet werden.

Bekannt und Stand der Technik ist weiterhin, dass Blends (Mischungen) von nicht-konjugierten Polymeren, wie z. B. PVK (Poly-vinylcarbazol), mit niedermolekularen Metallkomplexen, welche einen Transfer sogenannter Singulett-Excitonen zu Triplett-Excitonen ermöglichen und welche aus dem Triplett-Zustand Licht emittieren können, in effizienter Elektrolumineszenz des Metallkomplexes resultieren. Solche Mischungen werden beispielsweise beschrieben von F.-C. Chen et al. (Appl. Phys. Lett. 2002, 80, 2308-2310). Gegenüber Metallkomplexen, die für eine Anwendung in einem aufwändigen und teuren Prozess aufgedampft werden müssen, bieten diese Blends den Vorteil, dass sie aus Lösung einfacher und kostengünstiger verarbeitbar sind. Jedoch sind die Betriebsspannungen für diese Systeme sehr hoch, was in einer sehr niedrigen Leistungseffizienz resultiert.

Blends aus niedermolekularen Metallkomplexen, die aus dem Triplett-Zustand Licht emittieren, mit konjugierten Polymeren sind in der Literatur ebenfalls beschrieben. T. F. Guo et al. (Organic Electronics 2000, 1, 15) und D. F. O'Brien et al. (Synth. Met. 2001, 116, 379) beschreiben gute Quanteneffizienzen mit Blends aus einem Platin-Porphyrin-Komplex mit Polyfluorenen, wobei in beiden Fällen die Effizienzen deutlich niedriger sind als bei vergleichbaren Devices aufgebaut aus kleinen Molekülen. W. Zhu et al. (Appl. Phys. Lett. 2002, 80, 2045-2047) beschreiben einen Blend aus einem löslichen Iridium-Phenylpyridin-Komplex mit einem Poly-paraphenylen. Hier wurden bessere, aber weiterhin relativ niedrige, Quanteneffizienzen gemessen. Insbesondere wurden für dieses System sehr hohe Spannungen benötigt, die einer technischen Anwendung im Wege stehen würden.

Es besteht hier also noch weiterhin großer Verbesserungsbedarf. Überraschend wurde gefunden, dass - bisher unbekannte - Blends (also Mischungen) aus den im Folgenden beschriebenen Polymeren mit Dendrimeren und/oder niedermolekularen Verbindungen und eventuell, aber nicht notwendigerweise, einem weiteren konjugierten oder auch nicht-konjugierten Polymer für die Anwendung hier unerwartete Vorteile bringen. Wie schon die Polymere POLY1 resultieren auch die erfindungsgemäßen Blends in steileren Strom-Spannungs-Kennlinien und damit in niedrigeren Betriebsspannungen.

Gegenstand der Erfindung sind also Blends (Mischungen) enthaltend
(A) 5 - 99,5 Gew.% mindestens eines konjugierten Polymers (POLY2), das 1 - 100 mol%, bevorzugt 5 - 100 mol%, besonders bevorzugt 10 - 100 mol% Einheiten gemäß Formel (XXXII) enthält, 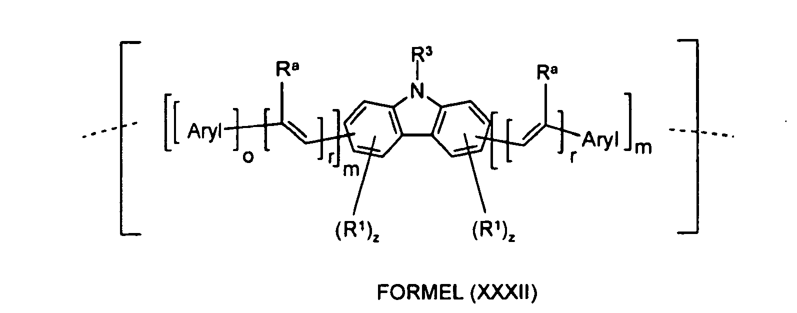 wobei die Symbole und Indizes folgende Bedeutung besitzen:
   - R³: ist bei jedem Auftreten gleich oder verschieden einer linearen oder verzweigten Alkylkette mit 1 bis 40 C-Atomen, die substituiert oder auch unsubstituiert sein kann, einem Cycloalkylsystem mit 3 bis 40 C-Atomen, das substituiert oder auch unsubstituiert sein kann, einem aromatischen oder heteroaromatischen Ringsystem mit 2 bis 40 C-Atomen, welches jeweils substituiert oder unsubstituiert sein kann, oder einem Alkylenaryl-, Alkylencycloalkyl- oder Alkylenheteroaryl- System, welches substituiert oder auch unsubstituiert sein kann; die möglichen Substituenten R¹ können dabei potentiell an jeder freien Position sitzen; die Aryl- und Heteroaryl-Systeme können auch Teil eines größeren kondensierten aromatischen Ringsystems sein;
   die weiteren Symbole und Indizes besitzen dieselbe Bedeutung, wie oben unter Formel (I) beschrieben;
   und
(B) 0,5 - 95 Gew.% mindestens eines organischen oder metallorganischen Dendrimeren oder mindestens eines niedermolekularen Moleküls im Molekulargewichtsbereich < 10.000 bedeutet (VERB1), welches mindestens ein d-Übergangsmetall enthält, welches im reinen oder verdünnten Film zu Fluoreszenz oder Phosphoreszenz befähigt ist, und welches eine ausreichende Löslichkeit in geeigneten Lösungsmitteln, bevorzugt Toluol, Xylol, Anisol, THF, Methylanisol oder Methylnaphathalin, aufweist, um im Blend gemeinsam mit dem Polymer aus Lösung in diesem Lösungsmittel verarbeitet zu werden.

Bevorzugt beträgt der Anteil des Dendrimers oder der niedermolekularen Verbindung im Blend 0,5 bis 80 Gew.%, besonders bevorzugt 1 bis 50 Gew.%, insbesondere 2 bis 25 Gew.%.

Bevorzugt beträgt der Anteil des Polymeren (POLY2) im Blend 20 bis 99,5 Gew.%, besonders bevorzugt 50 bis 99 Gew.%, insbesondere 75 bis 98 Gew.%.

Unter Dendrimer soll hier eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum, als auch die Monomere beliebige verzweigte Strukturen annehmen, die sowohl aus rein organischen Einheiten, als auch Organometallverbindungen oder Koordinationsverbindungen bestehen. Dendrimer soll hier allgemein so verstanden werden, wie dies beispielsweise in M. Fischer, F. Vögtle, Angew. Chem., Int. Ed. 1999, 38, 885-905 beschrieben ist.

Die Struktureinheit gemäß Formel (XXXII) ist Bestandteil von Homopolymeren und Copolymeren, wie bereits für die Struktureinheit gemäß Formel (I) beschrieben. Dabei kommen auch hier dieselben Comonomere wie beispielsweise die in den Beispielen gezeigten Monomere M1 bis M23 in Frage. Die Synthese dieser Polymere kann nach den oben beschriebenen Methoden durchgeführt werden. Dabei hat sich gezeigt, dass für Blends, die aus dem Singulettzustand Licht emittieren, ein Anteil im Bereich von 10 mol% Struktureinheiten gemäß Formel (XXXII) im Polymer POLY2 gute Ergebnisse erzielt. Für andere Anwendungen, insbesondere für Blends, die aus dem Triplettzustand Licht emittieren, kann es bevorzugt sein, einen höheren Anteil als 10 mol% Struktureinheiten gemäß Formel (XXXII) im Polymer POLY2 vorliegen zu haben.
Bevorzugt ist für Blends, die aus dem Triplettzustand Licht emittieren, ein Anteil von 20 - 100 mol% Struktureinheiten gemäß Formel (XXXII) im Polymer POLY2. Besonders bevorzugt ist für diese Blends ein Anteil von 30 - 100 mol% Struktureinheiten gemäß Formel (XXXII).

Für bevorzugte Polymere POLY2 gilt Folgendes:
- R³: ist bei jedem Auftreten gleich oder verschieden einer linearen oder verzweigten Alkylkette mit 1 bis 40 C-Atomen, die substituiert oder auch unsubstituiert sein kann, einem aromatischen oder heteroaromatischen Ringsystem, ausgewählt aus Thiophen, Benzothiophen, Benzol, Pyridin, Chinoxalin, Fluoren, Spirobifluoren, Naphthalin, Anthracen, Pyren oder Phenanthren, welches an den freien Positionen 0 bis 3 Substituenten R¹ trägt, oder einem Alkylenaryl- oder Alkylenheteroaryl-Ringsystem, dessen Alkylen-Kette linear oder verzweigt sein kann und aus 1 bis 16 C-Atomen besteht und dessen Aryl- und Heteroaryl-System aus den oben im einzelnen aufgeführten Systemen besteht, welche an den freien Positionen 0 bis 3 Substituenten R¹ tragen;
die weiteren Symbole und Indizes haben dieselbe Bedeutung wie bereits oben für bevorzugte Strukturen gemäß Formel (I) beschrieben.

Für besonders bevorzugte Polymere POLY2 gilt Folgendes:
- R³: ist bei jedem Auftreten gleich oder verschieden einer linearen oder verzweigten Alkylkette mit 2 bis 30 C-Atomen, die substituiert oder auch unsubstituiert sein kann, einem aromatischen oder heteroaromatischen Ringsystem, ausgewählt aus Thiophen, Benzothiophen, Benzol, Pyridin, Naphthalin, Anthracen, Pyren oder Phenanthren, welche unsubstituiert oder mit einem Substituenten R¹ substituiert sind, oder einem 9,9'-substituierten Fluoren oder einem Methylenaryl- oder Methylenheteroaryl-Ringsystem, dessen Aryl- bzw. Heteroaryl-System aus den oben im einzelnen aufgeführten Systemen besteht, welche dasselbe Substitutionsmuster tragen können wie die oben genannten Systeme;
die weiteren Symbole und Indizes haben dieselbe Bedeutung wie bereits oben für besonders bevorzugte Strukturen gemäß Formel (I) beschrieben.

Für ganz besonders bevorzugte Polymere POLY2 gilt Folgendes:
- R³: ist bei jedem Auftreten gleich oder verschieden einer linearen oder verzweigten Alkylkette mit 3 bis 20 C-Atomen, die substituiert oder auch unsubstituiert sein kann, einem aromatischen oder heteroaromatischen Ringsystem, ausgewählt aus Thiophen, Benzothiophen, Benzol, Naphthalin, Anthracen, oder Phenanthren, welche unsubstituiert oder mit einem Substituenten R¹ substituiert sind, oder einem Benzyl-Ringsystem, dessen Phenylgruppe dasselbe Substitutionsmuster tragen kann wie die oben genannten Systeme;
die weiteren Symbole und Indizes haben dieselbe Bedeutung wie bereits oben für ganz besonders bevorzugte Strukturen gemäß Formel (I) beschrieben.

Die im Blend verwendeten Dendrimere oder niedermolekularen Verbindungen VERB1 können aus den unterschiedlichsten Substanzklassen ausgewählt werden. Bevorzugt sind hier Blends aus Polymeren POLY2 mit einem oder mehreren Dendrimeren oder einer oder mehreren niedermolekularen Verbindungen, welche einen Transfer von sogenannten Singulett-Excitonen zu Triplett-Excitonen ermöglichen und welche auch bei Raumtemperatur mit hoher Effizienz aus dem Triplettzustand Licht emittieren können: Dies sind zunächst vor allem Verbindungen, welche Schweratome, d. h. Atome aus dem Periodensystem der Elemente mit einer Ordnungszahl von mehr als 36, enthalten. Besonders geeignet sind hierfür Verbindungen, welche d- und f-Übergangsmetalle enthalten, die die o. g. Bedingung erfüllen. Ganz besonders bevorzugt sind hier entsprechende Struktureinheiten, welche Elemente der Gruppe 8 bis 10 (d. h. Ru, Os, Rh, Ir, Pd, Pt) enthalten. Als solche niedermolekularen Struktureinheiten kommen hier z. B. verschiedene Komplexe, welche beispielsweise in den Anmeldeschriften WO 02/068435, WO 02/081488, EP 1239526 und der nicht offen gelegten Anmeldeschrift DE 10238903.9 beschrieben sind, in Frage. Als Dendrimer-Strukturen kommen hierfür Komplexe, wie beispielsweise in den Anmeldeschriften WO 99/21935, WO 01/059030 und WO 02/066552 beschrieben sind, in Frage.

Die erfindungsgemäßen Blends weisen gegenüber dem o. g. Stand der Technik u. a. folgende überraschenden Vorteile auf:
- Der Strom bei gegebener Spannung ist bei vergleichbaren Blends bei der Verwendung in PLEDs deutlich höher (vgl. Angaben in Tabelle 3), d. h. die Strom-Spannungs-Kennlinie ist steiler, wenn die Polymerkomponente des Blends Struktureinheiten der Formel (XXXII) enthält. Dies bringt für die Anwendung - wie oben bereits ausgeführt - deutliche Vorteile, da somit das Ziel, effiziente Vollfarbdisplays mit geringerem Energieverbrauch zu erzeugen, ermöglicht wird.
- Überraschend hat die Verwendung von erfindungsgemäßen Blends mit Komponenten, die aus dem Triplett-Zustand emittieren, noch folgenden weiteren Vorteil: Der Energietransfer vom Polymer auf den Metallkomplex läuft in einem erfindungsgemäßen Blend effizienter ab als in vergleichbaren Blends, die keine Polymere POLY2 enthalten, was zu einer effizienteren Emission des Metallkomplexes führt (vgl. Angaben in Tabelle 3).
- Die Löslichkeit in organischen Lösemitteln ist i. d. R. gut, d. h. in Lösemitteln, wie beispielsweise Toluol, Xylol, Anisol, Methylanisol oder Methylnaphthalin, sind die Polymere POLY1 und Blends in Konzentrationen im Bereich von mindestens 1 bis 30 g/L (je nach Molekulargewicht) löslich. Als Lösemittel und Lösemittelgemische kommen beispielsweise diejenigen, wie sie in der Anmeldeschrift WO 02/072714 beschrieben bzw. zitiert sind, in Frage. Dies ist zwar keine Verbesserung gegenüber dem Stand der Technik an sich, jedoch ist es wichtig, dass diese Eigenschaft bei Einführung neuer Strukturen erhalten bleibt.

Die erfindungsgemäßen Blends können in PLEDs verwendet werden. Wie PLEDs hergestellt werden können, wird als allgemeines Verfahren ausführlich in DE 10249723.0 beschrieben, das entsprechend für den Einzelfall anzupassen ist.
- Wie oben bereits beschrieben, eignen sich die Polymere, die Einheiten gemäß Formel (I) enthalten, ganz besonders als Elektrolumineszenzmaterialien in derart hergestellten PLEDs oder Displays.

Wie oben beschrieben, eignen sich die erfindungsgemäßen Blends ganz besonders als Elektrolumineszenzmaterialien in den derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht), und/oder dass sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Blends in einer PLED, insbesondere als Elektrolumineszenzmaterial.

Gegenstand der Erfindung ist somit ebenfalls eine PLED mit einer oder mehreren aktiven Schichten, wobei mindestens eine dieser aktiven Schichten ein oder mehrere erfindungsgemäße Blends enthält. Die aktive Schicht kann beispielsweise eine lichtemittierende Schicht und/oder eine Transportschicht und/oder eine Ladungsinjektionsschicht sein.

PLEDs finden z. B. Anwendung als selbstleuchtende Anzeigeelemente, wie Kontrollampen, alphanumerische Displays, mehr- oder vollfarbige Displays, Hinweisschilder und in optoelektronischen Kopplern.

Im vorliegenden Anmeldetext und auch in den im Weiteren folgenden Beispielen wird auf die Verwendung erfindungsgemäßer Blends in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Blends auch für weitere Verwendungen in anderen elektronischen Devices (Vorrichtungen) zu benutzen, z. B. für organische integrierte Schaltungen (O-ICs), in organischen Feld-Effekt-Transistoren (OFETs), in organischen Dünnfilmtransistoren (OTFTs), für organische Solarzellen (O-SCs), nicht-lineare Optik oder auch organische Laserdioden (O-Laser), um nur einige Anwendungen zu nennen. Gerade für O-ICs und OFETs können entsprechende erfindungsgemäße Polymere, welche einen relativ hohen Anteil an Strukturelementen gemäß Formel (I) besitzen (bevorzugt einen Anteil von mehr als 20 mol%), Verwendung finden.

Die Erfindung wird durch die nachfolgenden Beispiele näher erläutert, ohne sie dadurch einschränken zu wollen.

### Beispiele

### Teil A: Synthese der Monomere und Blendbestandteile:

### A1: Monomere für Einheiten gemäß Formel (I)

3,6-Dibromcarbazol und 2,7-Dibromcarbazol wurden gemäß Smith et al., Tetrahedron 1992, 48, 7479-7488, und Tidwell et al., Eur. J. Med. Chem. 1997, 32, 781-793 synthetisiert. 3,6-Dibrom-N-ethylhexylcarbazol (= EHC) wurde gemäß J. Huang et al., Macromolecules 2002, 35, 6080-6082 synthetisiert.
Die strukturelle Integrität aller Produkte wurde mittels ¹H-NMR-Spektroskopie bewiesen, die Reinheit der Produkte wurde mittels HPLC bestimmt.

### Beispiel 1: N-(4-tert-Butylphenyl)-3,6-dibromcarbazol (EM1)

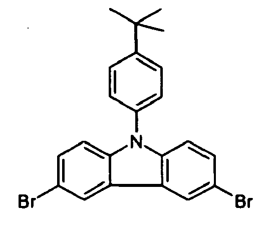

Eine entgaste Lösung von 17 g (80 mmol) 1-Brom-4-*tert*-butylbenzol in 1500 mL Xylol wurde 1 h mit N₂ gesättigt. Anschließend wurde die Lösung mit 500 g Glaskugeln (6 mm) und 15.37 g (160 mmol) K₃PO₄ versetzt und 15 min. nachgerührt. Nach 5 min Rühren wurde die Reaktionsmischung mit 90 mg (0.4 mmol) Palladium(II)acetat, 400 mg (2 mmol) P(t-Bu)₃ und 10 g (60 mmol) Carbazol versetzt. Die Reaktionsmischung wurde 4 h unter Rückfluss erhitzt. Nach Abkühlen wurde das Lösemittel im Vakuum entfernt und das Produkt aus n-Hexan umkristallisiert. Reinheit gem. HPLC: 99.6 %. Ausbeute: 13 g (68%).
¹H-NMR (CDCl₃, 500 MHz): 1.42 (s, 9 H), 7.26 (t, J₃ = 7.7 Hz, 2 H), 7.40 (m, 4 H), 7.48 (d, J = 8.7 Hz, 2 H), 7.59 (d, J = 8.7 Hz, 2 H), 8.14 (d, J = 8 Hz, 2 H).

12 g (40 mmol) N-(4-tert-Butylphenyl)carbazol und 70 g Kieselgel wurden in 700 mL CH₂Cl₂ vorgelegt. Anschließend wurde die Lösung unter Lichtausschluss bei 0 °C portionsweise mit 13 g (80 mmol) NBS versetzt und 2 h bei dieser Temperatur gerührt. Die Mischung wurde mit 100 mL Wasser versetzt und mit CH₂Cl₂ extrahiert. Die organische Phase wurde über MgSO₄ getrocknet und die Lösungsmittel in Vakuum entfernt. Das Produkt wurde mit Hexan heiß ausgerührt und filtriert. Ausbeute: 11 g (66 %) farbloses Pulver, welches eine HPLC-Reinheit von 99.2 % aufwies.
¹H-NMR (CDCl₃, 500 MHz): 1.42 (s, 9 H), 7.25 (d, J = 8.7 Hz, 2 H), 7.39 (d, J = 8.3 Hz, 2 H), 7.48 (dd, J₃ = 8.7 Hz, J₄ = 2 Hz, 2 H), 7.61 (d, J = 8.7 Hz, 2 H), 8.18 (d, J₄ =8Hz,2H).

### Beispiel 2: N-(4-tert-Butylphenyl)-2,7-dibromcarbazol (EM2)

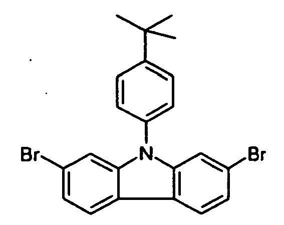

Eine entgaste Lösung von 489.5 mg (0.156 %) Kupfer(I)chlorid und 906 mg (1 %) mmol) 1,10-Phenanthrolin in 100 mL Toluol wurde 1 h mit N₂ gesättigt und auf 130 °C erhitzt. Anschließend wurde die Lösung mit 16.2 g (50 mmol) 2,7-Dibromcarbazol und 13.2 g (50 mmol) 1-lod-4-tert-butylbenzol versetzt und 2 h auf 180 °C erhitzt. Nach Abkühlen wurde die Mischung mit 180 mL Wasser versetzt, die organische Phase abgetrennt und das Lösemittel im Vakuum entfernt. Das Produkt wurde aus n-Hexan umkristallisiert. Ausbeute: 13 g (59 %). Reinheit gem. HPLC: 99.5 %
¹H-NMR (CDCl₃, 500 MHz): 1.43 (s, 9 H), 7.21 (t, J = 7.7 Hz, 2 H), 7.23 (t, J = 7.7 Hz, 2 H), 7.32 (dd, J₃ = 8.7 Hz, J₄ = 1.6 Hz, 2 H), 7.50 (d, J₄ = 1.6 Hz, 2 H), 7.89 (d, J=8.7Hz,2H).

### Beispiel 3: N-(4-tert-Butylphenyl)methyl-3,6-dibromcarbazol (EM3)

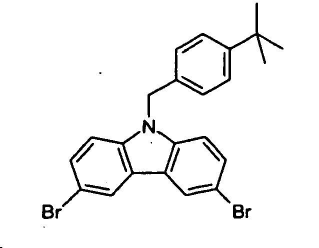

In einem 250 mL Einhalskolben mit Rückflusskühler wurden unter Schutzgas 990 mg (41.2 mmol) NaH in 80 mL trockenem DMF suspendiert. Zu dieser Reaktionsmischung wurden 10 g (30.8 mmol) 3,6-Dibromcarbazol in 80 mL DMF innerhalb 20 min bei RT zugetropft. Anschließend wurde eine Lösung von 4-(*tert-*butyl)benzylbromid in 50 mL DMF zugetropft und 8 h bei 60 °C erhitzt. Nach Abkühlen auf Raumtemperatur wurden vorsichtig 300 mL Wasser und 200 mL Ethylacetat zugesetzt. Die organische Phase wurde mit 4 x 50 mL H₂O gewaschen, dann über MgSO₄ getrocknet und die Lösungsmittel im Vakuum entfernt. Das reine Produkt erhielt man durch Umkristallisation aus n-Hexan. Ausbeute: 11 g (78 %); HPLC-Reinheit 99.4%.
¹H-NMR (CDCl₃, 500 MHz): 1.22 (s, 9 H), 5.42 (s, 2 H), 6.98 (d, J = 8.7 Hz, 2 H), 7.22 (d, J = 8.7 Hz, 2 H), 7.26 (d, J = 8.4 Hz, 2 H), 7.50 (dd, J₃ = 8.4 Hz, J₄ = 2 Hz, 2 H), 8.14 (d, J₄ = 2 Hz, 2 H).

### Beispiel 4: N-(4-tert-Butylphenyl)methyl-2,7-dibromcarbazol (EM4)

Die Synthese erfolgte in Analogie zu Beispiel 3, ausgehend von 2,7-Dibromcarbazol. Die Ausbeute betrug 94 %.
¹H-NMR (CDCl₃, 500 MHz): 1.21 (s, 9 H), 5.41 (s, 2 H), 6.97 (d, J = 8.7 Hz, 2 H), 7.23 (d, J = 8.7 Hz, 2 H), 7.33 (dd, J₃ = 8.7 Hz, J₄ = 1.6 Hz, 2 H), 7.51 (d, J₄ = 1.6 Hz, 2 H), 7.88 (d, J = 8.7 Hz, 2 H).

### Beispiel 5: N-(4-tert-Butylphenyl)-carbazol-3,6-biscarbaldehyd (EM5)

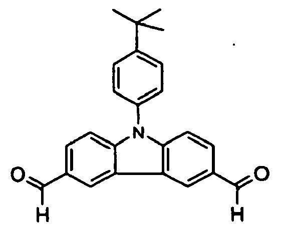

In einem 250 mL Dreihalskolben wurden unter Schutzgas 32 mmol **EM1** in 100 mL trockenem THF gelöst. Nach Abkühlung auf -78 °C wurde über ein Septum vorgekühltes BuLi (80 mmol, 15 %ig) unter Rühren in die Lösung injiziert. Unter weiterer Kühlung wurden nach 2 h bei -60 °C 5.2 mL DMF zugetropft. Man ließ auf RT erwärmen und rührte über Nacht weiter. Anschließend wurden vorsichtig 200 mL Eiswasser zugesetzt und mit Chloroform extrahiert. Die organische Phase wurde über MgSO₄ getrocknet und die Lösungsmittel in Vakuum entfernt. Das reine Produkt erhielt man durch Umkristallisation aus n-Hexan. Ausbeute: 8 g (68 %). Reinheit gem. HPLC: 99.1 %
¹H-NMR (CDCl₃, 500 MHz): 1.34 (s, 9 H), 6.38 (d, J = 8.1 Hz, 2 H), 6.82 (d, J = 8.7 Hz, 2 H), 7.04 (d, J = 8.1 Hz, 2 H), 7.18 (d, J = 8.7 Hz, 2 H), 7.31 (d, J = 8.7 Hz, 2 H), 9.2 (s, 2 H).

### Beispiel 6: 3,6-Bis- [2-(4-bromphenyl)ethenyl]-N-(4-tert-butylphenyl)-carbazol (EM6)

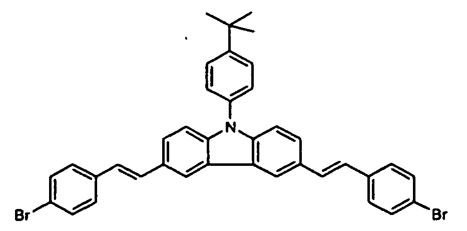

32 mmol 4-Brombenzyldiethylphosphonat wurden unter Schutzgas in 90 mL trockenem DMF gelöst und auf 5 °C gekühlt. Anschließend wurde 60 mmol NaO*^{t}*Bu in kleinen Portionen zugegeben, wobei die Temperatur 5 °C nicht überstieg. Nach 30 min wurden 14.7 mmol **EM5** in 25 mL DMF bei 5 °C zugetropft und noch weitere 30 min bei dieser Temperatur gerührt. Das Reaktionsgemisch wurde abgekühlt, 25 mL 4 M HCl zugetropft und der Niederschlag abgesaugt. Anschließend wurden vorsichtig 100 mL Wasser zugesetzt und mit CH₂Cl₂ extrahiert. Die organische Phase wurde über MgSO₄ getrocknet und die Lösungsmittel in Vakuum entfernt.

Das reine Produkt erhielt man durch Umkristallisation aus Ethylacetat/CH₂Cl₂-Mischung (1:1). Ausbeute: 79 g (90 %). Reinheit gemäß HPLC: 99.6 %
¹H-NMR (CDCl₃, 500 MHz): 1.33 (s, 9 H), 6.34 (d, J = 8.1 Hz, 2 H), 7.02 (d, J = 8.1 Hz, 2 H), 7.08 (d, J = 16.4 Hz, 2 H), 7.30 (d, J = 16.4 Hz, 2 H), 7.37 (d, J = 8.3 Hz, 2 H), 7.41 (d, J = 8.3 Hz, 4 H), 7.48 (d, J = 8.3 Hz, 4 H), 7.64 (dd, J₃ = 8.3 Hz, J₄ = 1.6 Hz, 2 H), 8.23 (d, J₄ = 1.6 Hz, 2 H).

Weitere Monomere gemäß Formel (I) bzw. Formeln (II) bis (XXXI) wurden in Analogie zu den oben genannten Beispielen synthetisiert.

### A2: Monomere für weitere Einheiten

Die Synthese der weiteren Monomere M1 bis M23 ist bereits in WO 02/077060 und der darin zitierten Literatur ausführlich beschrieben. Die Monomere sind zur besseren Übersicht im Folgenden nochmal dargestellt:

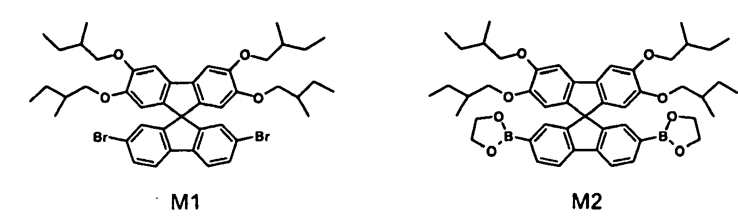

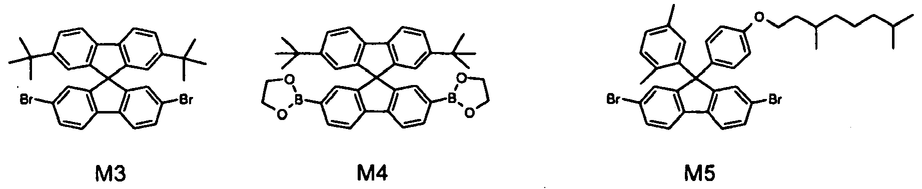

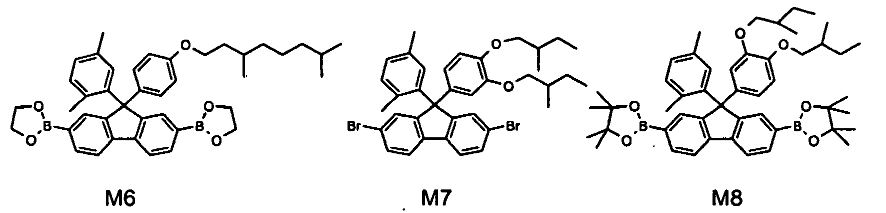

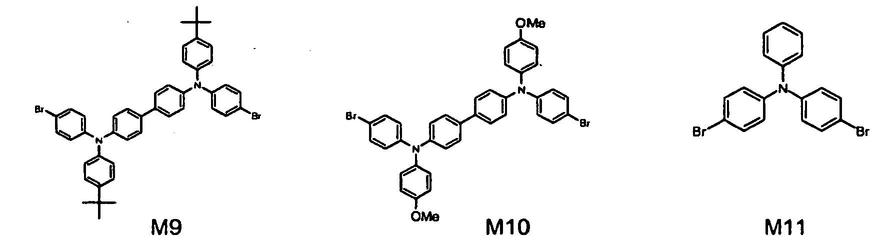

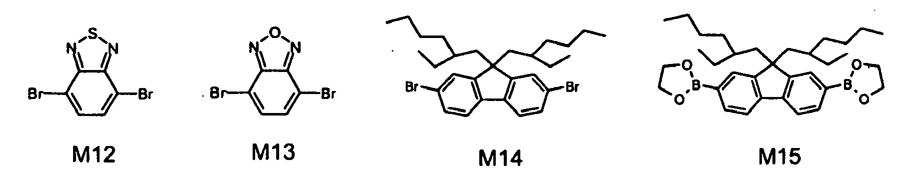

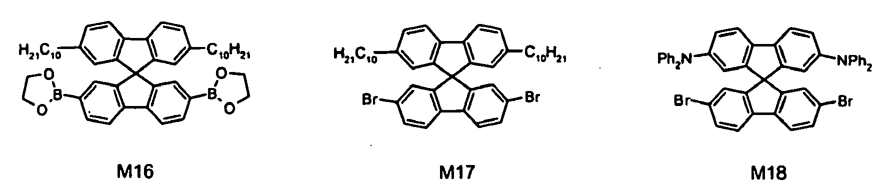

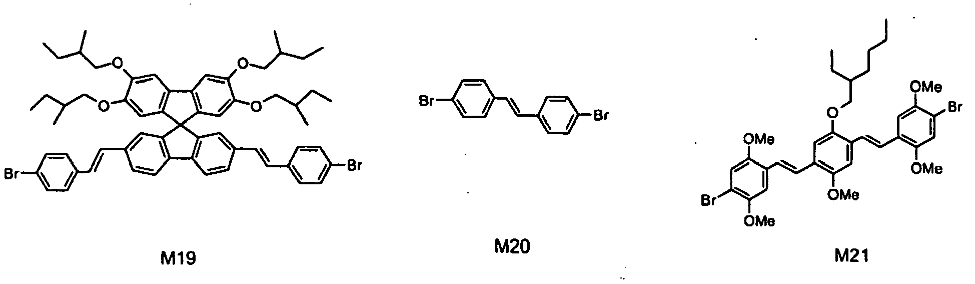

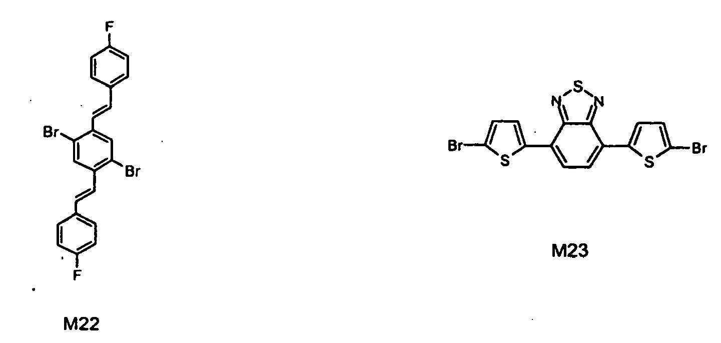

### A3: Niedermolekulare Verbindungen zur Verwendung in Blends

Bei den hier in erfindungsgemäßen Blends beispielhaft verwendeten niedermolekularen Verbindungen handelt es sich beispielsweise um lösliche Derivate von Tris(phenylpyridyl)-Iridium(III). Die Synthese dieser Verbindungen ist bereits beschrieben in der Anmeldeschrift WO 02/081488 und in der nicht offen gelegten Patentanmeldung DE 10238903.9. Es sei jedoch an dieser Stelle nochmals eindeutig darauf hingewiesen, dass sich die erfindungsgemäßen Blends nicht auf diese hier verwendeten niedermolekularen Verbindungen beschränken, sondern dass die nicht-polymere Komponente die oben genauer spezifizierten Verbindungen VERB1 sein können. Zur Übersicht sind die beiden beispielhaft hier verwendeten Iridium-Komplexe im Folgenden nochmals aufgeführt:

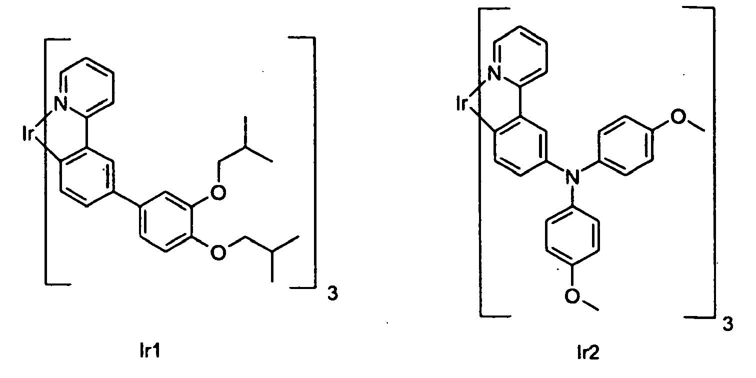

### Teil B: Herstellung der Polymere und Blends

### Synthese von Polymer P1:

3.2026 g (4 mmol) Monomer M2, 1.6237 g (2.4 mmol) Monomer M7, 0.6069 g (0.8 mmol) Monomer M9, 0.3770 g (0.8 mmol) EM1 und 3.91 g (2.125 Äquivalente) Kaliumphosphat Hydrat wurden gelöst in 37.5 mL Dioxan, 12.5 mL Toluol und 6.8 mL H₂O (alle Lösungsmittel sauerstofffrei). Die Reaktionslösung wurde 30 Minuten bei 40 °C mit Argon entgast. Dann wurden 0.45 mg (0.025 %) Pd(OAc)₂ und 3.65 mg (0.15 %) P(o-tolyl)₃ als Katalysator zugegeben, und die Lösung wurde 1.5 h unter Rückfluss unter einer Argon-Atmosphäre erhitzt. Die hochviskose Polymerlösung wurde mit 20 mL Toluol verdünnt. Dann wurde das Endcapping durchgeführt, indem 100 mg Benzolboronsäure zugegeben wurden, 45 Minuten unter Rückfluss erhitzt, dann Zugabe von 0.2 ml Brombenzol und weitere 45 Minuten unter Rückfluss erhitzt. Die Polymerlösung wurde bei 60 °C mit 100 ml 0.01 %-iger wässriger NaCN-Lösung 3 h gerührt. Dann wurden die Phasen getrennt und die organische Phase mit 4 x 100 mL H₂O gewaschen. Das Polymer wurde durch Zugabe des doppelten Volumens an Methanol ausgefällt und filtriert. Weitere Reinigung erfolgte durch Lösen in 200 mL Toluol bei 60 °C unter Argon, Filtration durch eine Glasfritte und erneute Ausfällung durch Zugabe des doppelten Volumens Methanol. Das Polymer wurde filtriert und unter Vakuum getrocknet. Es wurden 4.85 g (96 % d. Th.) Polymer isoliert, Mw = 578000, Mn = 156000, Polydispersität = 3.7.

### Synthese von Polymer P2:

Das Polymer wurde in Analogie zu Polymer P1 mit 3.2026 g (4 mmol) Monomer M2, 1.0825 g (1.6 mmol) Monomer M7, 0.6069 g (0.8 mmol) Monomer M9, 0.8185 g (0.8 mmol) Monomer M19, 0.3658 g (0.8 mmol) EM4 und 3.91 g (2.125 Äquivalente) Kaliumphosphat Hydrat in 25 mL Dioxan, 25 mL Toluol und 6.8 mL H₂O synthetisiert. Es wurden 4.57 g (92 % d. Th.) Polymer isoliert, Mw = 791000, Mn = 239000, Polydispersität = 3.3.

Weitere Polymere wurden analog der Beschreibung für P1 dargestellt. Die chemischen Eigenschaften sind in Tabelle 1 zusammengefasst. Es wurden auch einige Polymere, die keine Einheiten gemäß Formel (I) enthalten, dargestellt. Auch diese sind in der Tabelle mit aufgeführt.

### Herstellung der Blends:

Die Synthese der Blends erfolgt durch Lösen des Polymers zusammen mit dem Dendrimer oder der niedermolekularen Verbindung im gewünschen Verhältnis in einem geeigneten Lösungsmittel wie beispielsweise Toluol, Xylol, THF, Chlorbenzol oder Anisol und direktes Verarbeiten der Lösung ohne Isolierung des Blends in fester Substanz.

Alle Polymere und Blends wurden auch für einen Einsatz in PLEDs untersucht. Wie PLEDs dargestellt werden können, ist zum einen oben schon ausgeführt und wird in Teil C beschrieben.

Auch einige Device-Eigenschaften (Farbe, Effizienz und Betriebsspannung) sind in der Tabelle 1 mit aufgeführt.

In Tabelle 2 und Abbildung 1 sind die Strom-Spannungs-Charakteristika einiger Polymere dokumentiert. Hier kann man sehr gut erkennen, dass die Kurven bei den Polymeren, die Einheiten gemäß Formel (I) enthalten, deutlich steiler ansteigen und der Strom bei gegebener Spannung bei diesen Polymeren und erfindungsgemäßen Blends deutlich höher ist als bei den Polymeren, die keine Einheiten gemäß Formel (I) enthalten, bzw. Blends aus unkonjugierten Polymeren mit niedermolekularen Verbindungen gemäß Stand der Technik.

In Tabelle 3 sind einige Device-Eigenschaften (Farbe, Effizienz und Betriebsspannung) von erfindungsgemäßen Blends aufgeführt und verglichen mit Blends, die dem Stand der Technik entsprechen.

| | Anteil der Monomere in der Polymerisation [%] | | | | GPC** | | Elektrolumineszenz*** | | | | Visco.***** |
|---|---|---|---|---|---|---|---|---|---|---|---|
| Polymer (Typ)* | Monom.1 | Monom.2 | Monom.3 (+ evt. Mono. 4) | EM | M_{W} (·1000 g/mol) | M_{N} (·1000 g/mol) | λₘₐₓ [nm] | Max. Eff [Cd/A] | Spannung bei 100 Cd/m² [V] | CIE-Koordinaten**** (x/y) | Geltemp. [°C] |
| P1 (S) | 50% M2 | 30% M7 | 10% M9 | 10% EM1 | 578 | 156 | 449 | 3.10 | 4.7 | 0.15/0.12 | <0°C |
| P2 (S) | 50% M2 | 20% M7 | 10% M9, 10% M19 | 10% EM4 | 791 | 239 | 455/ 482 | 2.12 | 5.8 | 0.18/0.25 | <0°C |
| P3 (S) | 50% M2 | 40% M1 | | 10% EM2 | 624 | 132 | 433/ 449 | 2.25 | 4.4 | 0.16/0.10 | <0°C |
| P4 (S) | 50% M2 | | | 50% EM3 | 298 | 61 | 427 | 1.24 | 7.9 | 0.16/0.06 | |
| P5 (S) | 50% M2 | 30% M7 | 10% M19 | 10% EM3 | 824 | 204 | 454/ 481 | 5,06 | 3.6 | 0.17/0.25 | <0°C |
| P6 (S)^{a} | 50% M2 | | | 50% EHC^{b} | 298 | 61 | | | | | |
| P7 (S)^{a} | 50% M2 | | | 50% EM1 | 308 | 79 | | | | | |
| P8 (S)^{a} | 50% M2 | 40% M1 | | 10% EHC^{b} | 764 | 200 | | | | | |
| P9 (S)^{a} | 50% M2 | 10% M1 | 10% M9 | 30% EHC^{b} | 350 | 114 | | | | | |
| V1 (S) | 50% M2 | 40% M7 | 10% M9 | | 1190 | 199 | 464 | 3.42 | 4.9 | 0.16/0.17 | <0°C |
| V2 (S) | 50% M2 | 30% M7 | 10% M9, 10% M19 | | 464 | 126 | 459/ 484 | 5.31 | 4.2 | 0.18/0.29 | <0°C |
| V3 (S) | 50% M2 | 50% M1 | | | 207 | 63 | 433/ 449 | 1.38 | 4.8 | 0.16/0.11 | <0°C |
| V4 (S) | 50% M2 | 40% M7 | 10% M19 | | 520 | 170 | 461/ 483 | 3.99 | 4.1 | 0.16/0.25 | <0°C |

| | | | | | | | | | | | |
|---|---|---|---|---|---|---|---|---|---|---|---|
| Tabelle 1. *S = Durch Suzuki-Polymerisation hergestellt (vgl. Bsp. P1), Y = durch Yamamoto-Polymerisation hergestellt ** GPC Messungen THF; 1 ml/min, Plgel 10µm Mixed-B 2 x 300 x 7.5 mm², 35 °C, RI Detektion wurde gegen Polystyrol geeicht *** Zur Herstellung der Polymer LEDs, siehe Teil C **** CIE-Koordinaten: Chromatizitäts-Koordinaten der Commission Internationale de l'Eclairage *****Lösungen des Polymers (10mg/ml) in Toluol wurden auf 60 °C erwärmt, mit 1 °C/Minute abgekühlt und die Viscosität wurde in einem Brookfield LVDV-III Rheometer (CP-41) gemessen. Bei der so ermittelten Geltemperatur tritt ein starker Anstieg in der Viskosität auf. ^{a} Polymer P6 bis Polymer P9 wurden nur in Blends mit Triplettemittern (s. Tabelle 3) untersucht. ^{b} EHC = 3,6-Dibrom-N-ethylhexylcarbazol | | | | | | | | | | | |

**Tabelle 2.**

| **Polymer** | **Stromdichte (mA/cm²) bei einer Spannung von** | | | | |
|---|---|---|---|---|---|
| | 2 V | 3 V | 4 V | 5 V | 6 V |
| **P5** | 0 | 0.3 | 4.6 | 18.3 | 51.7 |
| **V2** | 0 | 0.2 | 2.6 | 12.3 | 38.0 |
| **V4** | 0 | 0.1 | 1.7 | 6.5 | 16.4 |

Vergleich des Stroms bei unterschiedlichen Spannungen (am Beispiel eines Polymeren, das Einheiten gemäß Formel (I) enthält, und zwei Polymeren ähnlicher Zusammensetzung, die jedoch keine Struktureinheiten gemäß Formel (I) enthalten).

Figur 1 zeigt einen Vergleich der Strom-Spannungs-Kennlinien für das Polymer P5 (enthaltend 10 % Carbazol) mit dem Polymer V2 (enthaltend 10 % des Lochleiters M9, aber kein Carbazol) und dem Polymer V4 (enthaltend keinen anderen Lochleiter und auch kein Carbazol).

| | Blend-Zusammensetzung | | | Elektrolumineszenz* | | | |
|---|---|---|---|---|---|---|---|
| Blend | Polymer | Iridium-Komplex | Anteil Ir-Komplex [%] | λₘₐₓ [nm] | Max. Eff. [cd/A] | Spannung bei 100 Cd/m² [V] | CIE1931-Koordinaten** (x / y) |
| B1 | P5 | Ir1 | 8 | 534 | 9.29 | 5.90 | 0.40/0.58 |
| B2 | P5 | Ir2 | 8 | 604 | 6.22 | 10.62 | 0.59/0.41 |
| B3 | P6 | Ir1 | 8 | 532 | 9.23 | 5.88 | 0.38/0.60 |
| B4 | P7 | Ir1 | 8 | 532 | 12.82 | 6.92 | 0.38/0.60 |
| B5 | P7 | Ir1 | 20 | 532 | 14.49 | 5.87 | 0.38/0.60 |
| B6 | P6 | Ir2 | 8 | 604 | 6.27 | 10.60 | 0.50/0.61 |
| B7 | P8 | Ir2 | 8 | 611 | 4.42 | 6.41 | 0.62/0.38 |
| B8 | P8 | Ir2 | 20 | 614 | 7.53 | 4.35 | 0.62/0.38 |
| B9 | P9 | Ir2 | 8 | 606 | 6.62 | 6.91 | 0.60/0.40 |
| | | | | | | | |
| VB1 | V3 | Ir1 | 8 | 529 | 0.65 | 6.33 | 0.36/0.55 |
| VB2 | V3 | Ir2 | 8 | 605 | 0.40 | 6.70 | 0.60/0.39 |
| VB3 | PVK*** | Ir1 | 8 | 520 | 7.13 | 13.71 | 0.37/0.60 |
| VB4 | PVK | Ir2 | 8 | 600 | 3.64 | 13.41 | 0.58/0.42 |

| | | | | | | | |
|---|---|---|---|---|---|---|---|
| Tabelle 3. * Zur Herstellung der Polymer LEDs, siehe Teil C ** CIE-Koordinaten: Chromatizitäts-Koordinaten der Commission Internationale de l'Eclairage von 1931 *** PVK = Poly(vinylcarbazol | | | | | | | |

)

### Teil C: Herstellung und Charakterisierung von LEDs:

Alle Polymere und Blends wurden für einen Einsatz in PLEDs untersucht. Diese PLEDs waren jeweils Zweischichtsysteme, d. h. Substrat//ITO//PEDOT//Polymer//Kathode. PEDOT ist ein Polythiophen-Derivat (Baytron P von H. C. Stark, Goslar). Als Kathode wurde in allen Fällen Ba/Ag (beide von Aldrich) verwendet. Wie PLEDs dargestellt werden können, ist in DE 10249723.0 und der darin zitierten Literatur ausführlich beschrieben.

## Patentansprüche

1. Mischungen, enthaltend
(A) 5 - 99,5 Gew.% mindestens eines konjugierten Polymers (POLY2), das 1-100 mol% Einheiten gemäß Formel (XXXII) enthält, 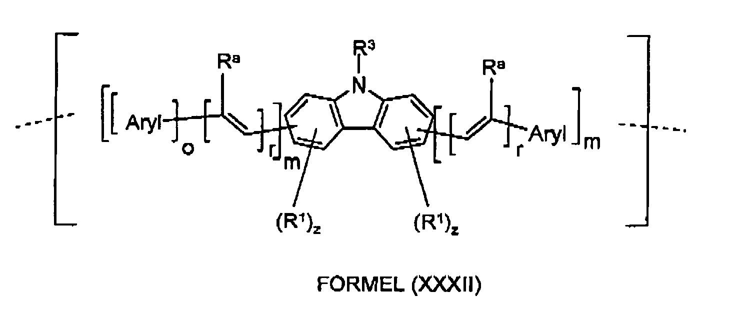 wobei die Symbole und Indizes folgende Bedeutung besitzen:
Aryl sind bei jedem Auftreten gleich oder verschieden einem aromatischen oder heteroaromatischen Ringsystem mit 2 bis 40 C-Atomen, welches substituiert oder auch unsubstituiert sein kann, oder eine substituierte oder unsubstituierte Stilbenylen- oder Tolanyleneinheit; die möglichen Substituenten R¹ können dabei potentiell an jeder freien Position sitzen;
R¹ ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R², O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht- aromatische Reste R¹ substituiert sein können, oder Cl, F, CN, N(R²)₂, B(R²)₂, wobei auch zwei oder mehrere Reste R¹ miteinander ein Ringsystem bilden können;
R^{a} ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R², O, S, -CO-O-, O-CO-O ersetzt sein können, wobei auch ein oder mehrere H- Atome durch Fluor ersetzt sein können, eine Aryl- oder Aryloxygruppe mit 5 bis 40 C-Atomen, bei der auch ein oder mehrere C-Atome durch O, S oder
R² N ersetzt sein können, welche auch durch ein oder mehrere nicht- aromatische Reste R¹ substituiert sein können, oder Cl, F, CN, N(R²)₂, B(R²)_{2'}; ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können;
R³ ist bei jedem Auftreten gleich oder verschieden einer linearen oder verzweigten Alkylkette mit 1 bis 40 C-Atomen, die substituiert oder auch unsubstituiert sein kann, einem Cycloalkylsystem mit 3 bis 40 C-Atomen, das substituiert oder auch unsubstituiert sein kann, einem aromatischen oder heteroaromatischen Ringsystem mit 2 bis 40 C-Atomen, welches jeweils substituiert oder unsubstituiert sein kann, oder einem Alkylenaryl-, Alkylencycloalkyl- oder Alkylenheteroaryl-System, welches substituiert oder auch unsubstituiert sein kann; die möglichen Substituenten R¹ können dabei potentiell an jeder freien Position sitzen; die Aryl- und Heteroaryl-Systeme können auch Teil eines größeren kondensierten aromatischen Ringsystems sein;
m ist bei jedem Auftreten gleich oder verschieden 0, 1 oder 2;
o ist bei jedem Auftreten gleich oder verschieden 0, 1 oder 2, unter der Bedingung, dass o nicht 0 sein darf, wenn m = 2 ist;
r ist bei jedem Auftreten gleich oder verschieden 0 oder 1,
z ist bei jedem Auftreten gleich oder verschieden 0, 1, 2 oder 3;
die gestrichelte Bindung stellt dabei die Verknüpfung im Polymer dar; sie soll hier keine Methylgruppe darstellen.
und
(B) 0,5 - 95 Gew.% mindestens eines organischen oder metallorganischen Dendrimeren oder mindestens eines niedermolekularen Moleküls im Molekulargewichtsbereich < 10.000 (VERB1), welches mindestens ein d-Übergangsmetall enthält, welches im reinen oder verdünnten Film zu Fluoreszenz oder Phosphoreszenz befähigt ist, und welches eine ausreichende Löslichkeit in geeigneten Lösungsmitteln aufweist, um im Blend gemeinsam mit dem Polymer aus Lösung in diesem Lösungsmittel verarbeitet zu werden.

2. Blends gemäß Anspruch 1, **dadurch gekennzeichnet, dass** die Komponente VERB1 des Blends aus einem oder mehreren Metallkomplexen besteht, welche einen Transfer von so genannten Singulett-Excitonen zu Triplett-Excitonen ermöglichen und welche aus dem Triplettzustand Licht emittieren.

3. Blends gemäß Anspruch 1 und/oder 2, **dadurch gekennzeichnet, dass** die VERB1 mindestens ein Übergangsmetall aus den Gruppen 8 bis 10 enthält.

4. Blends gemäß einem oder mehreren der Ansprüche 1 bis 3, **dadurch gekennzeichnet, dass** POLY2 30 - 100 mol% Struktureinheiten gemäß Formel (XXXII) enthält.

5. Verwendung eines Blends gemäß einem oder mehreren der Ansprüche 1 bis 4 in organischen integrierten Schaltungen (O-ICs), in organischen Feld-Effekt-Transistoren (OFETs), in organischen Dünnfilmtransistoren (OTFTs), in organischen Solarzellen (O-SCs), in organischen Leuchtdioden (OLED), in organischen Laserdioden (O-Laser) oder in der nicht-linearen Optik.

6. Elektronisches Bauteil, welches eine oder mehrere aktiven Schichten umfasst, wobei mindestens eine dieser aktiven Schichten ein oder mehrere Blends gemäß einem oder mehreren der Ansprüche 1 bis 4 enthält.

7. Elektronisches Bauteil gemäß Anspruch 6, **dadurch gekennzeichnet, dass** es sich um eine organische Leuchtdiode handelt.

## Claims

1. Mixtures comprising
(A) 5 - 99.5% by weight of at least one conjugated polymer (POLY2), which comprises 1 - 100 mol% of units of the formula (XXXII), 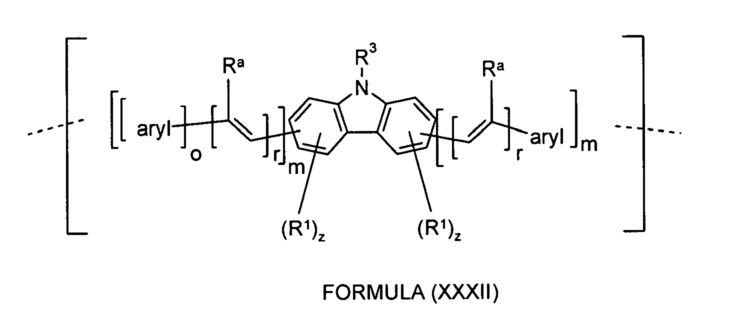 where the symbols and indices have the following meaning:
aryl is on each occurrence, identically or differently, an aromatic or heteroaro- matic ring system having 2 to 40 C atoms, which may be substituted or also unsubstituted, or a substituted or unsubstituted stilbenylene or tolanylene unit; the possible substituents R¹ here can potentially be in any free position;
R¹ is on each occurrence, identically or differently, a straight-chain, branched or cyclic alkyl or alkoxy chain having 1 to 22 C atoms, in which, in addition, one or more non-adjacent C atoms may be replaced by N-R², O, S, -CO-O-, O-CO-O, where, in addition, one or more H atoms may be replaced by fluo- rine, an aryl or aryloxy group having 5 to 40 C atoms, in which, in addition, one or more C atoms may be replaced by O, S or N, which may also be substituted by one or more non-aromatic radicals R¹, or Cl, F, CN, N(R²)₂, B(R²)₂, where, in addition, two or more radicals R¹ may form a ring system with one another;
R^{a} is on each occurrence, identically or differently, a straight-chain, branched or cyclic alkyl or alkoxy chain having 1 to 22 C atoms, in which, in addition, one or more non-adjacent C atoms may be replaced by N-R², O, S, -CO-O-, O-CO-O, where, in addition, one or more H atoms may be replaced by fluo- rine, an aryl or aryloxy group having 5 to 40 C atoms, in which, in addition, one or more C atoms may be replaced by O, S or N, which may also be
R² substituted by one or more non-aromatic radicals R¹, or Cl, F, CN, N(R²)₂, B(R²)₂; is on each occurrence, identically or differently, H, a straight-chain, branched or cyclic alkyl chain having 1 to 22 C atoms, in which, in addition, one or more non-adjacent C atoms may be replaced by O, S, -CO-O-, O-CO-O, where, in addition, one or more H atoms may be replaced by fluorine, an aryl group having 5 to 40 C atoms, in which, in addition, one or more C atoms may be replaced by O, S or N, which may also be substituted by one or more non-aromatic radicals R¹;
R³ is on each occurrence, identically or differently, a linear or branched alkyl chain having 1 to 40 C atoms, which may be substituted or also unsubstitu- ted, a cycloalkyl system having 3 to 40 C atoms, which may be substituted or also unsubstituted, an aromatic or heteroaromatic ring system having 2 to 40 C atoms, which may in each case be substituted or unsubstituted, or an alkylene-aryl, alkylene-cycloalkyl or alkylene-heteroaryl system, which may be substituted or also unsubstituted; the possible substituents R¹ here can potentially be in any free position; the aryl and heteroaryl systems may also be part of a larger condensed aromatic ring system;
m is on each occurrence, identically or differently, 0, 1 or 2;
o is on each occurrence, identically or differently, 0, 1 or 2, with the condition that o cannot be 0 if m = 2;
r is on each occurrence, identically or differently, 0 or 1;
z is on each occurrence, identically or differently, 0, 1, 2 or 3;
the dashed bond here represents the link in the polymer; it is not intended to represent a methyl group here,
and
(B) 0.5 - 95% by weight of at least one organic or organometallic dendrimer or at least one low-molecular-weight molecule in the molecular-weight range < 10,000 (COMP1) which contains at least one d transition metal, which, in a pure or diluted film, is capable of fluorescence or phosphorescence, and which has adequate solubility in suitable solvents in order to be processed from solution in this solvent in a blend together with the polymer.

2. Blends according to Claim 1, **characterised in that** component COMP1 of the blend consists of one or more metal complexes which facilitate transfer of so-called singlet excitons to triplet excitons and which emit light from the triplet state.

3. Blends according to Claim 1 and/or 2, **characterised in that** COMP1 contains at least one transition metal from groups 8 to 10.

4. Blends according to one or more of Claims 1 to 3, **characterised in that** POLY2 comprises 30 - 100 mol% of structural units of the formula (XXXII).

5. Use of a blend according to one or more of Claims 1 to 4 in organic integrated circuits (O-ICs), in organic field-effect transistors (O-FETs), in organic thin-film transistors (O-TFTs), in organic solar cells (O-SCs), in organic light-emitting diodes (OLEDs), in organic laser diodes (O-lasers) or in non-linear optics.

6. Electronic component which comprises one or more active layers, where at least one of these active layers comprises one or more blends according to one or more of Claims 1 to 4.

7. Electronic component according to Claim 6, **characterised in that** it is an organic light-emitting diode.

## Revendications

1. Mélanges comprenant
(A) 5 - 99,5% en poids d'au moins un polymère conjugué (POLY2), lequel comprend 1 - 100 %mol d'unités de la formule (XXXII), 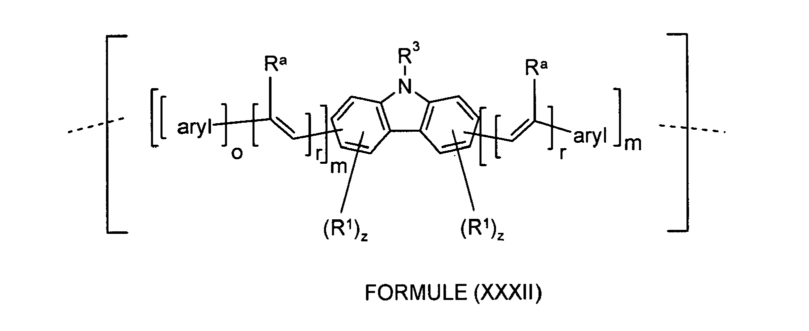 dans laquelle les symboles et indices présentent la signification qui suit :
aryl est, pour chaque occurrence, de manière identique ou différente, un sys- tème de cycle aromatique ou hétéroaromatique comportant 2 à 40 atomes de C, lequel peut être substitué ou également non substitué, ou une unité stilbénylène ou tolanylène substituée ou non substituée ; les substituants possibles R¹ peuvent ici potentiellement être en n'importe quelle position libre ;
R¹ est, pour chaque occurrence, de manière identique ou différente, une chaîne alkyle ou alcoxy en chaîne droite, ramifiée ou cyclique comportant 1 à 22 atomes de C, dans laquelle, en plus, un ou plusieurs atomes de C non adjacents peuvent être remplacés par N-R², O, S, -CO-O-, O-CO-O, dans laquelle, en plus, un ou plusieurs atomes de H peuvent être remplacés par fluor, un groupe aryle ou aryloxy comportant 5 à 40 atomes de C, dans lequel, en plus, un ou plusieurs atomes de C peuvent être remplacés par O, S ou N, lequel peut également être substitué par un ou plusieurs radicaux non aromatiques R¹, ou Cl, F, CN, N(R²)₂, B(R²)₂, dans lequel, en plus, deux radicaux R¹ ou plus peuvent former un système de cycle l'un avec l'autre;
R^{a} est, pour chaque occurrence, de manière identique ou différente, une chaîne alkyle ou alcoxy en chaîne droite, ramifiée ou cyclique comportant 1 à 22 atomes de C, dans laquelle, en plus, un ou plusieurs atomes de C non adjacents peuvent être remplacés par N-R², O, S, -CO-O-, O-CO-O, dans
R² laquelle, en plus, un ou plusieurs atomes de H peuvent être remplacés par fluor, un groupe aryle ou aryloxy comportant 5 à 40 atomes de C, dans lequel, en plus, un ou plusieurs atomes de C peuvent être remplacés par O, S ou N, lequel peut également être substitué par un ou plusieurs radicaux non aromatiques R¹, ou Cl, F, CN, N(R²)₂, B(R²)₂; est, pour chaque occurrence, de manière identique ou différente, H, une chaîne alkyle en chaîne droite, ramifiée ou cyclique comportant 1 à 22 atomes de C, dans laquelle, en plus, un ou plusieurs atomes de C non adja- cents peuvent être remplacés par O, S, -CO-O-, O-CO-O, dans laquelle, en plus, un ou plusieurs atomes de H peuvent être remplacés par fluor, un groupe aryle comportant 5 à 40 atomes de C, dans lequel, en plus, un ou plusieurs atomes de C peuvent être remplacés par O, S ou N, lequel peut être substitué par un ou plusieurs radicaux R¹ non aromatiques ;
R³ est, pour chaque occurrence, de manière identique ou différente, une chaîne alkyle linéaire ou ramifiée comportant 1 à 40 atomes de C, laquelle peut être substituée ou également non substituée, un système cycloalkyle comportant 3 à 40 atomes de C, lequel peut être substitué ou également non substitué, un système de cycle aromatique ou hétéroaromatique com- portant 2 à 40 atomes de C, lequel peut dans chaque cas être substitué ou non substitué, ou un système alkylène-aryle, alkylène-cycloalkyle ou alkyl- ène-hétéroaryle, lequel peut être substitué ou également non substitué ; les substituants possibles R¹ peuvent ici être potentiellement en n'importe quelle position libre ; les systèmes aryle et hétéroaryle peuvent également être une partie d'un système de cycle aromatique condensé plus grand ;
m est, pour chaque occurrence, de manière identique ou différente, 0, 1 ou 2 ;
o est, pour chaque occurrence, de manière identique ou différente, 0, 1 or 2, sous condition que o ne peut pas être 0 si m = 2 ;
r est, pour chaque occurrence, de manière identique ou différente, 0 ou 1 ;
z est, pour chaque occurrence, de manière identique ou différente, 0, 1, 2 ou 3;
la liaison en pointillés représente ici la liaison dans le polymère ; elle n'est pas destinée à représenter ici un groupe méthyle,
et
(B) 0,5 - 95% en poids d'au moins un dendrimère organique ou organométallique ou au moins une molécule de poids moléculaire faible dans la plage de poids moléculaires < 10 000 (COMP1), lequel contient au moins un métal de transition d, lequel, dans un film pur ou dilué, est susceptible de fluorescence ou de phosphorescence, et lequel présente une solubilité adéquate dans des solvants appropriés afin d'être traité à partir d'une solution dans ce solvant selon un mélange en association avec ce polymère.

2. Mélanges selon la revendication 1, **caractérisés en ce qu'**un composant COMP1 du mélange est constitué par un ou plusieurs complexes métalliques qui facilitent un transfert de ce que l'on appelle des excitons singlets vers des excitons triplets et qui émettent de la lumière à partir de l'état triplet.

3. Mélanges selon la revendication 1 et/ou 2, **caractérisés en ce que** COMP1 contient au moins un métal de transition pris parmi les groupes 8 à 10.

4. Mélanges selon une ou plusieurs des revendications 1 à 3, **caractérisés en ce que** POLY2 comprend 30 - 100 %mol d'unités structurelles de la formule (XXXII).

5. Utilisation d'un mélange selon une ou plusieurs des revendications 1 à 4 dans des circuits intégrés organiques (O-ICs), des transistors à effet de champ organiques (O-FETs), des transistors à film mince organiques (O-TFTs), des cellules solaires organiques (O-SCs), des diodes émettrices de lumière organiques (OLEDs), des diodes laser organiques (O-lasers) ou des optiques non linéaires.

6. Composant électronique qui comprend une ou plusieurs couches actives, dans lequel au moins l'une de ces couches actives comprend un ou plusieurs mélanges selon une ou plusieurs des revendications 1 à 4.

7. Composant électronique selon la revendication 6, **caractérisé en ce qu'**il s'agit d'une diode émettrice de lumière organique.
